(19) Europäisches Patentamt
European Patent Office
Office européen des brevets

(11) **EP 2 998 700 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**21.12.2022 Patentblatt 2022/51**

(45) Hinweis auf die Patenterteilung:
**07.12.2016 Patentblatt 2016/49**

(21) Anmeldenummer: **14185404.2**

(22) Anmeldetag: **18.09.2014**

(51) Internationale Patentklassifikation (IPC):
*G01C 15/00* (2006.01)    *G01C 3/08* (2006.01)
*G01S 17/08* (2006.01)    *G01S 17/10* (2020.01)
*G01S 17/89* (2020.01)    *G01S 7/481* (2006.01)
*G01S 7/486* (2020.01)    *G01S 7/491* (2020.01)
*H01L 31/10* (2006.01)    *H01L 31/107* (2006.01)

(52) Gemeinsame Patentklassifikation (CPC):
**G01C 15/002; G01S 7/4816; G01S 7/4817;**
**G01S 7/4861; G01S 17/10; G01S 17/42;**
**H01L 31/02024; H01L 31/107; H01L 31/165;**
G01S 7/4868

(54) **Elektrooptischer Distanzmesser und Distanzmessverfahren**

Electro-optical distance gauge and distance measuring method

Dispositif de mesure de distance électro-optique et procédé de mesure de distance

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**23.03.2016 Patentblatt 2016/12**

(73) Patentinhaber: **Hexagon Technology Center GmbH**
**9435 Heerbrugg (CH)**

(72) Erfinder:
• **Hinderling, Jürg**
**CH-9437 Marbach (CH)**

• **Singer, Julien**
**CH-9442 Berneck (CH)**

(74) Vertreter: **Kaminski Harmann**
**Patentanwälte AG**
**Landstrasse 124**
**9490 Vaduz (LI)**

(56) Entgegenhaltungen:
**WO-A1-2011/029651    DE-A1- 10 051 302**
**DE-A1-102006 013 290    US-A1- 2009 059 183**

EP 2 998 700 B2

**Beschreibung**

Die Erfindung betrifft ein elektrooptisches Distanzmessgerät und Distanzmessverfahren.

Zum Vermessen eines Zielpunktes sind seit der Antike eine Vielzahl von geodätischen Verfahren bzw. geodätischen Geräten bekannt. Als räumliche Standarddaten werden dabei Entfernung und Winkel von einem Messgerät zu einem zu vermessenden Zielpunkt aufgenommen sowie insbesondere der Ort des Messgerätes nebst evtl. vorhandenen Bezugspunkten erfasst.

Solche Vermessungsgeräte werden zur Erfassung von dreidimensionalen Objekten oder Oberflächen verwendet. Dabei tasten diese Geräte typischerweise eine dreidimensionale Struktur, wie z.B. die Struktur eines Bauwerks, mit Laserpulsen sukzessive ab und berechnen dann aus den zurückerhaltenen Reflexionspulsen ein entsprechendes dreidimensionales Modell, das die Oberfläche des Objekts beschreibt.

Ein allgemein bekanntes Beispiel für solche Vermessungsgeräte bzw. geodätische Geräte stellt ein Theodolit, ein Tachymeter oder eine Totalstation dar, die auch als elektronischer Tachymeter oder Computer-Tachymeter bezeichnet wird. Eine solche geodätische Messvorrichtung des Stands der Technik ist beispielsweise in der Veröffentlichungsschrift EP 1 686 350 beschrieben. Derartige Geräte verfügen über elektrosensorische Winkel- und Distanzmessfunktionen, welche eine Richtungs- und Distanzbestimmung zu einem ausgewählten Ziel erlauben. Die Winkel- bzw. Distanzgrössen werden dabei im inneren Bezugssystem des Gerätes ermittelt und müssen für eine absolute Positionsbestimmung ggf. noch mit einem äusseren Bezugssystem verknüpft werden.

Als Laserscanner ausgebildete Vorrichtungen zum optischen Abtasten einer Umgebung umfassen üblicherweise einen auf einer Basis gelagerten Messkopf, der bezüglich dieser Basis um eine Basisdrehachse drehbar ist. Im Messkopf sind auf einer Seite Laserlichtquelle und Lichtsensor für den Empfang reflektierter Laserpulse untergebracht sowie eine Sende- und Empfangsoptik und eine Austrittsöffnung, die Aus- bzw. Eintritt der Strahlung aus bzw. in das Gehäuse erlaubt. Auf der anderen Seite des Messkopfes, der Austrittöffnung vis à vis, weist der Messkopf einen Rotationsspiegel zur Umlenkung von Sendelichtstrahl und Empfangslichtstrahl auf, der um eine auf der Basisachse senkrecht stehende Rotationsachse drehbar ist. Der Schnittpunkt der beiden Drehachsen entspricht in der Regel dem Auftreffpunkt des Sendelichtstrahlstrahls auf dem Rotationsspiegel, wobei der Rotationsspiegel im Allgemeinen um einen Winkel von 45° geneigt zu den Drehachsen angeordnet ist. Durch Drehung des Messkopfes um die Basisdrehachse und Rotation des Rotationsspiegels um die Rotationsachse, ist es möglich einen dreidimensionalen Scan durchzuführen.

Bei einer anderen Topologie wird statt einem Drehspiegel das gesamte optische Sende- und Empfangsmodul rotiert. Ein Beispiel einer solchen Anordnung sind scannende Theodolite.

Heutige Distanzmesser, welche in Produkten wie Theodolite, Scanner, LIDAR-Systeme ("light detection and ranging"), Profiler, Lasertracker oder auch in Automobilen eingesetzt sind, haben das Problem der Handhabung hoher Signaldynamik.

Des Weiteren wird bei einigen dieser Produkte der Sensorstrahl mittels einer Ablenkeinheit, insbesondere eines Scanners, mit hoher Geschwindigkeit verschwenkt. Damit der vom Zielobjekt zurückreflektierte Empfangsstrahl den Empfänger trifft, muss dieser mit einem grossen Gesichtsfeld (FOV) ausgelegt sein. Empfänger mit grossem Gesichtsfeld haben bei Tageslicht oder Umgebungslicht jedoch den Nachteil von Schrotrauschen, was bei Distanzmessern die Reichweite reduziert und Distanzrauschen erzeugt.

Distanzmesssensoren für geodätische oder industrielle Vermessungsgeräte sind fast ausschliesslich mit einer Avalanche-Photodiode (APD) als Detektor mit Zeitauflösung im Pikosekundenbereich ausgerüstet. Diese APD haben in der Regel eine runde Empfangsfläche. Bekannt sind auch APD mit Empfangsflächen, die mit einer Maske, bestehend aus mehreren Öffnungen, abgedeckt sind.

All diese Avalanche-Photodioden nach dem Stand der Technik haben eine unter der Maske liegende, gemeinsame empfindliche photosensitive Fläche. Es wird bei Lichteinfall lediglich ein einziger Photostrom erzeugt.

Bekannt sind auch APD-Arrays. Solche Arrays haben eine matrixartige Anordnung von Sensorelementen, welche beispielsweise für hochsensitive Messungen zur bildgebenden Objektdarstellung eingesetzt werden. Der insensitive Abstand zwischen den Sensorelementen ist dabei im Allgemeinen recht gross. Solche Arrays haben typischerweise den Nachteil eines kleinen Füllfaktors (<50%), und die Anzahl der Pixel und der entsprechenden Signale nimmt quadratisch mit der Fläche zu, was die Signalverarbeitung recht aufwendig und teuer gestaltet. Bei herkömmlichen APD wird darauf geachtet, dass Crosstalk zwischen den Elementen möglichst niedrig ist (typischerweise < 5%). Diese Anforderung ist bei der vorliegenden Erfindung für die Lösung des zugrunde liegenden Problems nicht relevant.

Herkömmliche Distanzmessvorrichtungen müssen einen hohen Signaldynamikbereich handhaben. Dabei werden unter Verwendung einer einflächigen Avalanche-Photodiode sowohl die Grenzen hinsichtlich der von der APD selbst handhabbaren Stromstärke erreicht als auch die Empfangselektronik gelegentlich übersteuert (Übersättigung). Bei gewissen Vorrichtungen wird die emittierte Sendeleistung angepasst; bei anderen wird die Verstärkung des Empfängers eingestellt, bei wiederum anderen wird ein mehrkanaliger Empfänger verwendet.

Der Sendequelle, beispielsweise ausgebildet als Laser, LED etc. Nachgeschaltete optische Faserverstärker sind besonders geeignet, um die Sendeleistung über einen grossen Bereich einzustellen. Solche Lichtverstärker sind jedoch nicht mit Mikrosekunden-Intervallen einstellbar. Heutige Scanner messen aber mit einer Punktrate von wenigstens einer Million Punkten pro Sekunde. Es gibt hingegen variable optische Abschwächer (VOA) die mit Nanosekunden-Geschwindigkeit einstellbar sind, solche Bauteile benötigen eine entsprechend leistungsstarke Ansteuerung und sind im Vergleich zu den anderen üblichen Bauteilen eines typischen Distanzmessgeräts teuer.

Ferner treten - hauptsächlich bei empfängerseitigen Fixfokusanordnungen - bei bekannten Detektoranordnungen aus dem Stand der Technik in der Regel Abschattungen des Empfangslichts im Nahbereich (z.B. < 5m) auf. Diese führen dazu, dass in einem sehr nahen Distanzbereich von 0m bis zu einer gewissen Grenzdistanz gar kein Signal durch die APD erfasst wird. Damit wird also der Entfernungsbereich reduziert, innerhalb welchem überhaupt Ziele messbar bzw. deren Distanzen bestimmbar sind.

Eine Vorrichtung zur optischen Entfernungsmessung nach dem Stand der Technik ist weiter in der DE102006013290 beschrieben.

Eine erste Aufgabe der Erfindung ist die Bereitstellung eines Entfernungsmessers mit hinsichtlich Signaldynamik, Signalrauschverhältnis und/oder Nachbereichsempfangbarkeit verbessertem Detektor, insbesondere Avalanche-Photodiode, zum Empfangen optischer Strahlung und Erzeugen eines resultierenden elektrischen Signals.

Spezielle Aufgaben der Erfindung sind die Ermöglichung einer Verringerung der erforderlichen zu gewährleistenden Signaldynamik und damit Verringerung von Komplexität und Kosten der Vorrichtung sowie die Ermöglichung präziser Distanzbestimmungen sowie für Ziele in einem kurzen als auch einem grossen Entfernungsbereich, verbunden mit niedriger Komplexität der Vorrichtung.

Eine weitere spezielle Aufgabe der Erfindung ist die Anhebung der Signalstärke bei ganz kurzen Distanzen, bei welchen bisher durch Abschattungen des Empfangsbündels nur schwaches oder sogar unzureichendes Messlicht empfangen werden konnte.

Weitere spezielle Aufgaben der Erfindung sind eine Erleichterung einer Lösung des bei Distanzmessungen auftretenden Eindeutigkeitsproblems, wenn innerhalb eines Messungstakts mehrere Lichtpulse zwischen einem Sender und einem Empfänger unterwegs sind, und die Unterdrückung von Distanzmessungen zu Fehlzielen, welche insbesondere ein Problem bei Distanzmessungen mit luftgestützten LIDAR-Systemen eine Rolle spielen.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Ein erster Gegenstand der Erfindung ist ein Detektor von einem Distanzmessgerät, insbesondere in einem Laserscanner, Lasertracker, Profiler, LIDAR, Theodolit oder einer Totalstation, mit einem photosensitiven Empfangsbauteil zum Empfangen optischer Strahlung und Erzeugen eines resultierenden elektrischen Signals, welche eine Zeitintervallbestimmung insbesondere im Piko- oder Subpiko-Sekundenbereich zulässt.

Erfindungsgemäss ist der Detektor eine segmentierte Avalanche-Photodiode APD und das Empfangsbauteil weist mindestens zwei voneinander unabhängige APD-Segmente als Empfangssegmente auf, die vordefinierten, unterschiedlichen, zu vermessenden Distanzbereichen zugeordnet sind.

Die zwei voneinander unabhängige Empfangssegmente sind zum voneinander unabhängigen Erzeugen je eines resultierenden elektrischen Signals vorgesehen und so ausgebildet und in einer Empfangsebene angeordnet, dass diese zu vordefinierten, unterschiedlichen, zu vermessenden Distanzbereichen zugeordnet sind.

Ferner sind im Rahmen der Empfangsschaltung auch für die mindestens zwei Empfangssegmente mindestens zwei unabhängige, unterschiedliche Verstärkungsfaktoren aufweisende Verstärker vorgesehen. Dadurch kann vorteilhaft der erforderliche Bereich der erfassbaren Signaldynamik, der im Fall von unsegmentierten Detektoren nach dem Stand der Technik durch das einzige verfügbare Empfangssegment zu erfüllen ist, verringert werden auf kleinere notwendige Signaldynamikbereiche, die durch die erfindungsgemäss mehreren voneinander unabhängigen Empfangssegmente abzudecken sind. Damit werden sowohl die resultierenden Anforderungen an eine Signalverarbeitungselektronik als auch Kosten der Vorrichtung vermindert.

Insbesondere überlappen die voneinander unabhängigen Empfangssegmente nicht und sind jeweils zueinander beabstandet.

Dadurch wird eine Unterscheidung der Signale in Abhängigkeit von der zu bestimmenden Entfernung zu einem Zielobjekt erleichtert.

Gemäss einer Ausführungsform sind die voneinander unabhängigen Empfangssegmente radial verteilt, im Speziellen konzentrisch-kreisförmig, angeordnet.

Eine solche Gestaltung der Geometrie eines erfindungsgemässen Detektors entspricht der Grössen- und/oder Raumverteilung des Auftreffpunkts bzw. Auftreffspots (Empfangslichtbündel) der vom zu vermessenden Objekt zurückkommenden Empfangslichtstrahlen.

Gemäss einer speziellen Ausführungsform sind erste Segmente zentral und weitere Segmente peripher und zueinander achsensymmetrisch angeordnet. Eine derartige symmetrische, geometrische Platzierung der Segmente ist bei Aufbauten vorteilhaft, wo Sende- und Empfangskanal koaxial aufgebaut sind. Bei biaxialen Anordnungen von Sende- und Empfangslichtstrahlen in Distanzmessgeräten ist ein Versatz zwischen optischen Achsen der Sende- und Empfangslichtstrahlbündel beim Auftreffen auf dem Detektor zu erwarten. Bei solchen Anordnungen sind je nach Anforderung an das Distanzmessgerät sowohl radialsymmetrische als auch asymmetrische Segmentanordnungen des Empfangsbauteils eine Lösung.

Gemäss einer Ausführungsform sind Abstände zwischen benachbarten Empfangssegmenten gleich oder voneinander verschieden, vorteilhaft insbesondere zur Bestimmung unterschiedlicher Distanzbereiche durch verschiedene Empfangssegmente.

Gemäss einer speziellen Ausführungsform sind dezidierte, insbesondere periphere, Empfangssegmente in ihrer Dimensionierung angepasst für den Empfang grossflächiger Empfangslichtspots für eine Bestimmung kurzer Distanzen zu einem Zielobjekt.

Damit wird das Signal-Rausch-Verhältnis (SNR) des zugeordneten Distanzmesssignals von Objekten in Nahbereichen verbessert, insbesondere weil eine Abschattung von zentralen Empfangslichtbereichen umgangen werden kann, da das zugeordnete APD-Segment neben dem Abschattbereich platziert ist.

Ein weiterer Aspekt der Erfindung bezieht sich darauf, dass jedem Empfangssegment ein dezidierter, insbesondere für unterschiedliche Empfangssegmente jeweils separater, Signalverarbeitungspfad zugeordnet ist.

Gemäss einer Ausführungsform der erfindungsgemässen elektrooptischen Empfangsbaugruppe mit Empfangsschaltung sind voneinander verschiedene Signalpfade separat elektronisch ansteuerbar und/oder auslesbar, insbesondere wobei Signale von unterschiedlichen Empfangssegmenten aus zugeordneten unterschiedlichen Signalpfaden voneinander unterscheidbar auslesbar sind. Die Steuerung der Signalpfade kann entweder durch direktes Schalten der Hochspannung an den APD-Segmenten oder durch Schalten mittels externen Bauelementen wie Transistoren erfolgen.

Die Verstärkung der Signale von unterschiedlichen Empfangssegmenten in den zugeordneten Signalpfaden ist unterschiedlich gewählt, im Speziellen separat voneinander regulierbar. Dies ermöglicht z.B., dass für ein erstes Empfangssegment, welches einem oberen Distanzbereich vergleichsweise ferner Distanzen zugeordnet ist, ein Verstärker mit vergleichsweise hohem Verstärkungsfaktor vorgesehen sein kann, und für ein zweites Empfangssegment, welches einem unteren Distanzbereich vergleichsweise naher Distanzen zugeordnet ist, ein Verstärker mit vergleichsweise geringem Verstärkungsfaktor (sodass hier ein Übersteuern auch bei aus kurzen Distanzen kommenden, hochamplitudigen Empfangssignalen vermieden werden kann).

Die beiden zuletzt genannten Ausführungsformen ermöglichen vorteilhaft einerseits also eine Anpassung der im Signalpfad zu verarbeitenden Signale an die vom zugehörigen Empfangssegment gelieferten Signalamplituden. Insbesondere wird durch eine individuelle Einstellbarkeit der Signal-verstärkung auch eine Optimierung des Signal-zu-Rauschen-Verhältnisses erleichtert. Andererseits erleichtert die separate Auslesbarkeit von Signalen unterschiedlicher Empfangssegmente über zugeordnete voneinander verschiedene Signalpfade die Zuordnung der potentiellen zugehörigen Entfernungsbereiche zum Zielobjekt, was hilfreich bei einer Lösung eines potentiell auftretenden Mehrdeutigkeitsproblems bei der Entfernungsbestimmung ist (z.B. das bekannte "Zwei-Pulse-in-der-Luft"-Problem).

Gemäss einer weiteren Ausführungsform der erfindungsgemässen elektrooptischen Baugruppe ist die Dimensionierung von Empfangssegmenten und der Verstärkung in den zugehörigen Signalpfaden aufeinander abgestimmt, insbesondere für eine Minimierung einer resultierenden Variation zwischen starken und schwachen Signalen als Signaldynamik und/oder weiteren Vergrösserung eines Signal-zu-Rauschen-Verhältnisses für die einzelnen Signalpfade.

Dadurch können die Anforderungen an die Signalverarbeitungselektronik und damit die Vorrichtungskosten weiter vermindert werden.

Bereits bei einer Laserschussrate von 5MHz sind bei Objektdistanzen von mehr als 30m mehr als ein Signalimpuls gleichzeitig in der Luft. Mittels einer segmentierten APD, bei welcher beispielhaft ein erstes Segment dem Distanzbereich < 30m und ein zweites Segment dem Distanzbereich > 3m zugeordnet ist, kann somit eine eindeutige Zuordnung von korrespondierenden Sende- zu Empfangspulsen möglich gemacht werden. Eine geeignete APD-Segmentierung würde beispielsweise bestehen aus einem runden inneren Sensorelement (als das zweite Segment) und einem aussen anschliessenden, kreisringförmigen Sensorelement (als das erste Segment). Das äussere kreisringförmige erste Element/Segment empfängt dabei nur reflektierte Signale von Objekten aus dem ersten Eindeutigkeitsbereich < 30m und das innere Sensorelement/-segment empfängt nur reflektierte Signale von Objekten aus dem Bereich > 3m. Ein derartiges Lösen der Mehrdeutigkeit von mehreren Impulsen zwischen Sender und Empfänger vereinfacht die Sendemodulation. Üblicherweise wird die Sendequelle mittels bekannten Modulationstechniken, wie Frequenzmodulation, Amplitudenmodulation (AFK), Phasen oder Zeitintervall-Modulation (PSK, FSK) etc. angesteuert, um eine eindeutige Zuordnung von Sende- und Empfangssignalpulsen bei der Signalauswertung zu ermöglichen, was erfindungsgemäss nun ggf. entfallen kann.

Die Empfangssegmente können also - wie mit obigem Beispiel exemplarisch illustriert - erfindungsgemäss so ausgebildet und angeordnet sein, dass aus den unterschiedlichen Distanzbereichen zurückgestreute Lichtsignale unterschiedliche definierte Empfangssegmentkombinationen beleuchten (d.h. entweder nur ein bestimmtes Empfangssegment für einen definierten Distanzbereich oder mehrere bestimmte Empfangssegmente in einer eindeutigen Kombination für einen definierten Distanzbereich).

Bei obigem Beispiel würde es sich wie folgt verhalten:

- reflektierte Lichtsignale von Objekten im Distanzbereich > 30m werden nur durch das innere, zweite Segment erfasst,

- reflektierte Lichtsignale von Objekten im Distanzbereich < 30m und > 3m werden durch beide Segmente erfasst und

- reflektierte Lichtsignale von Objekten im Distanzbereich < 3m werden nur durch das äussere, erste Segment erfasst.

Die Tatsache, welches Segment ein Lichtsignal erhält bzw. welche Segmente in entsprechender Kombination jeweils Lichtsignale erhalten, kann also bereits als Grobdistanzschätzer herangezogen werden. Werden dann jeweils noch die Signalstärken (bzw. bei Segment-Kombinationen die Signalstärkeverteilung) herangezogen, kann eine Grobdistanz noch etwas genauer geschätzt werden.

Das erfindungsgemässe Distanzmessgerät, insbesondere für einen Laserscanner, Lasertracker, Profiler, LIDAR, Theodolit oder eine Totalstation, ist im Detail dabei ausgestattet mit wenigstens einer Lichtquelle zum Aussenden wenigstens eines Lichtsignals als Sendelichtstrahl, insbesondere von Laserlicht, auf ein Zielobjekt, einer Empfangsschaltung mit einem photoempfindlichen Detektor als Empfänger zum Detektieren eines vom Zielobjekt zurückgestreuten Lichtsignals als Empfangslichtstrahl, und einer Steuer- und Auswertekomponente zum Bestimmen einer Distanz zum Zielobjekt.

Wie zuvor ausgeführt ist dabei der Empfänger ausgebildet als ein segmentierter Detektor/Empfänger für hohe elektrische Trägerfrequenzen (von z.B. zwischen 100MHz und 1GHz), und die Empfangsschaltung umfasst eine erfindungsgemässe elektrooptische Baugruppe, jeweils nach einer der vorgenannten Ausführungsformen.

Die vorliegenden Erfindung ist insbesondere für derartige Entfernungsmesser relevant, bei welchen der Sendelichtstrahl im Wesentlichen kollimiert ist, also höchstens eine Divergenz von 0.5°, im Speziellen von 0.01°, aufweist, und dem Detektor eine Bündelungsoptik mit Fixfokus vorgeordnet ist, insbesondere wobei der Detektor in der Brennebene der Bündelungsoptik positioniert ist (also auf unendlich fokussiert ist).

Gemäss einer Ausführungsform des erfindungsgemässen elektrooptischen Distanzmessgeräts sind der Sendelichtstrahl und der Empfangslichtstrahl koaxial zueinander angeordnet.

Gemäss einer weiteren Ausführungsform sind der Sendelichtstrahl und der Empfangslichtstrahl biaxial zueinander angeordnet.

Dadurch, dass jedem Empfangssegment ein dezidierter, insbesondere für unterschiedliche Empfangssegmente jeweils separater, Signalverarbeitungspfad zuordenbar ist, kann ausserdem ein elektronisches Übersprechen von Signalen von unterschiedlichen Empfangssegmenten zumindest vermindert, im besten Fall sogar gänzlich verhindert, werden.

Grundsätzlich ist jedoch elektronisches Übersprechen eines empfangenen Lichtpulses auf mehrere APD-Segmente nicht unbedingt störend. Für eine Distanzbestimmung bieten sich mehrere Möglichkeiten an. Es kann beispielsweise nur das Zeitsignal des Segments ausgewertet werden, welches die grösste Impulsamplitude (SNR) aufweist. Es können aber auch die elektronisch verstärkten Signale von mehreren Segmenten zusammengefasst werden, anschliessend einem Analog Digitalwandler zugeführt, einer Echtzeit-Signalauswerteeinheit (FPGA) und schliesslich algorithmisch die Distanz bestimmt werden. Anderseits kann zusätzlich auch die Verteilung der Signalstärken aller den APD-Segmenten zugeordneten Signalkanäle bewertet werden. Daraus können diverse Parameter der Anordnung zwischen Distanzmessgerät und dem mindestens einen Zielobjekt ermittelt werden. Beispielsweise kann eine Distanzgrobschätzung abgeleitet werden, um eine eindeutige Pulszuordnung zu erreichen, falls sich mehrere Lichtpulse gleichzeitig zwischen Sender und Empfänger unterwegs befinden. Dies erspart die übliche Impulskodierung oder Signalmodulation wie sie aus den Telekom-Anwendungen bekannt sind. Mehrere Lichtpulse zwischen Sender und Empfänger sind bei schnellen Sendepulsraten bereits ab mittleren Distanzen zu handhaben. Bei einer Messrate von 5MHz sind bei Objektdistanzen von grösser als 30m bereits 2 Lichtpulse in der Luft unterwegs.

Ein weiterer Gegenstand der Erfindung ist ein elektrooptisches Distanzmessverfahren mit wenigstens einem Aussenden eines Lichtsignals als Sendelichtstrahl, insbesondere von Laserlicht, von einer Lichtquelle auf ein Zielobjekt, Detektieren eines vom Zielobjekt zurückkommenden Anteils des ausgesandten Lichtsignals als Empfangslichtstrahl mit einem Detektor als Empfänger und einer dem Detektor nachgeschalteten Signalverarbeitungselektronik, und Bestimmen einer Distanz zum Zielobjekt mit einer Steuer- und Auswertekomponente.

Erfindungsgemäss ist der Empfänger ausgebildet als ein segmentierter Detektor, und die Empfangsschaltung umfasst eine erfindungsgemässe elektrooptische Baugruppe, jeweils nach einer der vorgenannten Ausführungsformen.

Gemäss einer Ausführungsform des erfindungsgemässen Verfahrens werden Signale von unterschiedlichen Empfangssegmenten des erfindungsgemässen segmentierten Detektors aus zugeordneten unterschiedlichen Signalpfaden voneinander unterscheidbar ausgelesen, und es wird aus dem Vergleich von Signalen dieser unterschiedlichen Empfangssegmente eine Distanz zu dem Zielobjekt eindeutig bestimmt, insbesondere unter Berücksichtigung einer ermittelten Grösse und/oder Form eines Empfangslichtspots.

Gemäss einer weiteren Ausführungsform des erfindungsgemässen Verfahrens, insbesondere unter Verwendung eines LIDAR-Systems, werden Signale von unterschiedlichen Empfangssegmenten des segmentierten Detektors aus zugeordneten unterschiedlichen Signalpfaden voneinander unterscheidbar ausgelesen, und es wird eine Distanzbestimmung zu Fehlzielen, insbesondere durch Lichtstreuung an Luftpartikeln (bedingt z.B. durch Aerosole, Staub, Wolken, Nebel, Schneefall), durch Ausschluss vordefinierter oder vordefinierbarer Minimaldistanzen unterbunden.

Gemäss einer weiteren Ausführungsform des erfindungsgemässen Verfahrens, insbesondere durch schnelles Verschwenken des Laserstrahls erzeugten radialen Versatzes des Empfangslichtflecks von der optischen Achse, werden Signale von unterschiedlichen Empfangssegmenten des segmentierten Detektors aus zugeordneten unterschiedlichen Signalpfaden voneinander unterscheidbar ausgelesen, und es wird in einem ersten Schritt der Datenauswertung eine Grobdistanzbestimmung und in einem zweiten Schritt eine Feindistanzbestimmung durchgeführt.

Das erfindungsgemässe Verfahren und die erfindungsgemässe Vorrichtung werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:

Fig. 1: ein als Totalstation ausgebildetes geodätisches Vermessungsgerät nach dem Stand der Technik;

Fig. 2: eine schematische Darstellung eines als Laserscanner 1' ausgebildeten Vermessungsgeräts zum optischen Abtasten der Umgebung des Vermessungsgeräts nach dem Stand der Technik;

Fig. 3a: eine Illustration der Ausleuchtung eines als Avalanche-Photodiode ausgebildeten Detektors bei koaxialer Anordnung von Sender und Empfänger, d.h. von Sendelichtstrahlen und Empfangslichtstrahlen;

Fig. 3b: eine Illustration der Ausleuchtung eines als Avalanche-Photodiode ausgebildeten Detektors bei biaxialer Anordnung von Sender und Empfänger, d.h. von Sendelichtstrahlen und Empfangslichtstrahlen;

Fig. 4a: die Signalvariation als Funktion der Distanz mit einer einfachen, nicht segmentierten AvalanchePhotodiode APD nach dem Stand der Technik für zwei verschiedene Positionen der APD im Empfangsstrahlengang;

Fig. 4b: eine Illustration der Signalvariation als Funktion der Distanz für eine erfindungsgemässe segmentierte Avalanche-Photodiode APD, im Vergleich zum Signalverlauf einer unsegmentierten APD gemäss Fig. 4a;

Fig. 5: einen beispielhaften Signalverlauf der empfangenen optischen Leistungen von einer erfindungsgemässen zweisegmentigen APD als Funktion der Distanz zu einem Zielobjekt;

Fig. 6a: eine Illustration einer erste Ausführungsform einer erfindungsgemässen segmentierten Avalanche-Photodiode APD, als Beispiel für einen erfindungsgemässen Detektor, und ihren Einsatz in einer koaxialen Anordnung von Sender und Empfänger bei unterschiedlichen Distanzen vom Zielobjekt zur APD;

Fig. 6b: eine Illustration einer zweiten Ausführungsform einer segmentierten Avalanche-Photodiode APD, als Beispiel für einen erfindungsgemässen Detektor, und ihren Einsatz in einer biaxialen Anordnung von Sender und Empfänger bei unterschiedlichen Distanzen vom Zielobjekt zur APD;

Fig. 7a: eine Illustration der Lichtverteilung in der Empfangslicht-Ebene bei einer Scannbewegung, beispielsweise unter Verwendung eines rotierenden Spiegels, für eine koaxiale Anordnung von Sender und Empfänger;

Fig. 7b: eine Illustration, wie der reflektierte Empfangslichtstrahl im Fall eines rotierenden Scanner-Spiegels von der optischen Achse weggelenkt und dadurch eine radiale Verschiebung der Position des Empfangslichtspots auf dem Detektor erzeugt wird;

Fig. 7c: in einer zu Fig. 7a analogen Darstellung eine Illustration der Lichtverteilung in der Empfangslichtebene bei Scanning, d.h. unter Verwendung eines rotierenden Spiegels, für eine biaxiale Anordnung von Sender und Empfänger;

Fig. 8: eine weitere Ausführungsform einer erfindungsgemässen segmentierten APD für einen Einsatz im Zusammenhang mit einem schnell drehenden Scanner-Spiegel;

Fig. 9: eine Illustration einer erfindungsgemässen Problemlösung, insbesondere für Scanning mit einem rotierenden Scanner-Spiegel;

Fig. 10: ein Blockschaltbild für die Signalverarbeitung im Signalpfad eines erfindungsgemässen Detektors bzw. einer erfindungsgemässen APD;

Fig. 11a: eine Illustration einer Anwendung einer erfindungsgemässen segmentierten APD bei LIDAR für eine Unterdrückung einer Detektion von Fehlsignalen, insbesondere infolge von Störungen durch Schwebeteilchen, Staub oder Dichteschwankungen bei Luftbewegungen, bei einer koaxialen Anordnung von Sender und Empfänger; und

Fig. 11b: eine zu Fig. 11a analoge Illustration einer Anwendung einer erfindungsgemässen segmentierten APD bei LIDAR für eine Unterdrückung einer Detektion von Fehlsignalen, insbesondere infolge von Störungen durch Schwebeteilchen bei Luftbewegungen, bei einer biaxialen Anordnung von Sender und Empfänger.

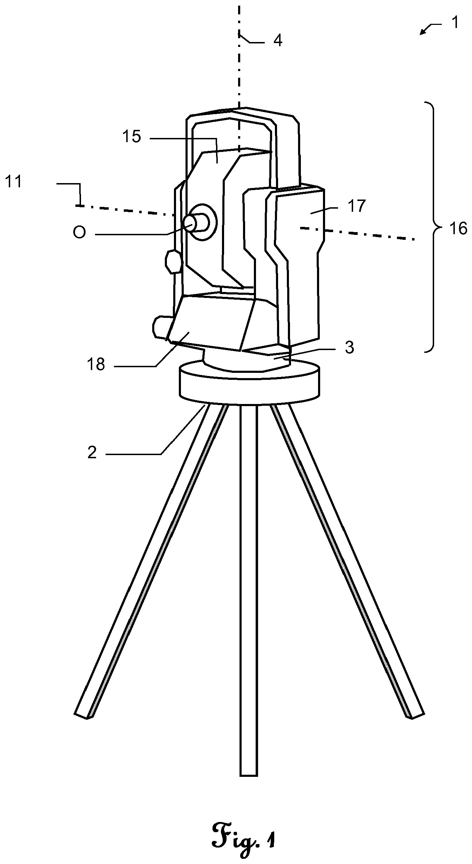

Fig. 1 zeigt, als Beispiel für den Stand der Technik, ein als Totalstation 1 ausgebildetes geodätisches Vermessungsgerät 1 zur Messung von Horizontalwinkeln, Vertikalwinkeln (was Schwenkstellungen von einer Stütze 17 und einer Anzieleinheit bzw. Visiereinrichtung 15 entspricht) und Distanzen zu einem beabstandeten und anvisierten Ziel.

Die Totalstation 1 kann - wie in Fig. 1 gezeigt - auf einem Stativ 2 angeordnet sein, wobei eine Basis 3 der Totalstation 1 direkt und fest mit dem Stativ 2 verbunden ist. Der Hauptkörper der Totalstation 1, der auch als Oberteil 16 bezeichnet wird, ist relativ zur Basis 3 um eine vertikale Stehachse 4 drehbar.

Das Oberteil 16 weist dabei eine - z.B. durch zwei Säulen gebildete - Stütze 17, eine zwischen den Säulen um eine horizontale Drehachse 11 drehbar gelagerte Visiereinrichtung 15 sowie ein elektronisches Datenverarbeitungs- und Anzeige-Modul 18 auf, welches durch eine Steuer- und Auswerteeinheit sowie ein Display gebildet wird, auf. Das elektronische Datenverarbeitungs- und Anzeige-Modul 18 kann in bekannter Weise zur Steuerung des Vermessungsgeräts 1 sowie zur Verarbeitung, Anzeige und Speicherung von Messdaten ausgebildet sein.

Die Anzieleinheit bzw. Visiereinrichtung 15 ist an der Stütze 17 um die horizontale Drehachse 11 drehbar angeordnet und kann somit zur Ausrichtung auf ein Zielobjekt relativ zur Basis 3 horizontal und vertikal geschwenkt bzw. gekippt werden. Dabei ist die Visiereinrichtung 15 als eine gemeinsame Visiereinrichtungs-Baueinheit ausgeführt, wobei zumindest ein Objektiv, eine Fokussieroptik, ein koaxialer Kamerasensor, eine optische Anziel-Strichkreuz-Platte und das Okular O in bzw. an einem gemeinsamen Visiereinrichtungs-Gehäuse angeordnet sind.

Mittels der Visiereinrichtung 15 kann ein Zielobjekt angezielt und die Entfernung von der Totalstation 1 zu dem Zielobjekt elektrosensorisch erfasst werden. Ausserdem sind Mittel zum elektrosensorischen Erfassen der Winkelausrichtung des Oberteils 16 relativ zur Basis 3 und der Visiereinrichtung 15 relativ zur Stütze 17 vorgesehen. Diese elektrosensorisch erfassten Messdaten werden der Steuer- und Auswerteeinheit zugeführt und von dieser verarbeitet, so dass die Position des Zielpunkts relativ zur Totalstation durch Datenverarbeitungs- und Anzeige-Modul 18 ermittelbar, graphisch anzeigbar und speicherbar ist.

Heutzutage sind ferner auch scannende Totalstationen bekannt, dabei wird die Visiereinrichtung mit Distanzmesser motorisch um wenigstens eine der beide Achsen rotiert. Bei diesen als Scanner verwendeten Instrumenten wird sowohl der Sendestrahl als auch der Empfangsstrahl ohne eine Spiegelbewegung rasterförmig über ein Zielobjekt verschwenkt.

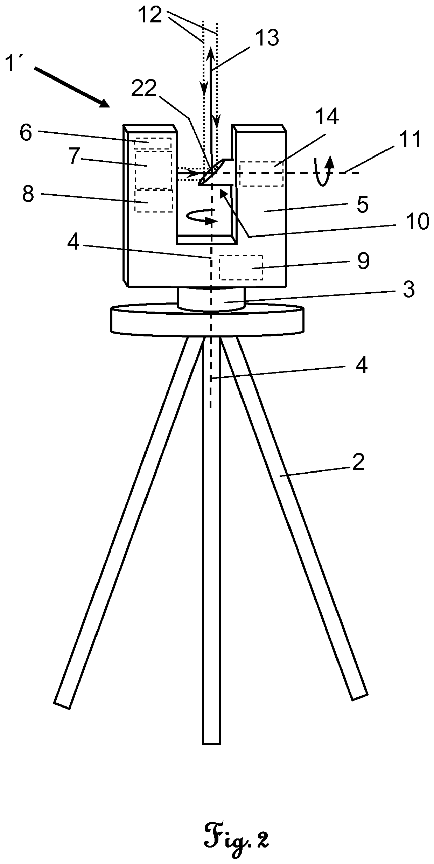

Fig. 2 zeigt, ebenfalls entsprechend dem Stand der Technik, eine schematische Darstellung eines als Laserscanner 1' ausgebildeten Vermessungsgeräts 1' zum optischen Abtasten der Umgebung des Vermessungsgeräts 1'. Das Vermessungsgerät 1' weist einen Messkopf mit einem Gehäuse 5 auf, das auf einer Basis 3 drehbar um eine Stehachse bzw. Basisachse 4 gelagert ist. Die Basis 3 ihrerseits ist auf einem Ständer montiert, der hier als Stativ 2 ausgebildet ist.

Dieser Laserscanner 1' weist eine zylindrische Rotationseinheit 10 mit einem Rotationsspiegel 22 auf, die zur Rotation um ihre horizontale Drehachse bzw. Zylinderachse 11 von einem in einem Motorgehäuse 14 angeordneten Motor angetrieben ist, wie in Fig. 2 durch gestrichelte Linien angedeutet. Wie ebenfalls in Fig. 2 durch gestrichelte Linien schematisch angedeutet, ist in einem der Rotationseinheit 10 gegenüberliegenden Teil des Gehäuses 5 eine Lichtquelle 6 zur Erzeugung eines Sendelichtstrahls 13 angeordnet, die insbesondere als Laserlichtquelle 6 ausgebildet ist und einen modulierten, insbesondere gepulsten und/oder in der Pulsfolge codierten, Laserstrahl aussenden kann. Des Weiteren sind in diesem Gehäuseteil ein photoempfindlicher Detektor 8 mit z.B. Pikosekunden-Zeitauflösung für Empfang und Detektion von Empfangslichtstrahlen 12, die aus der optisch abzutastenden Umgebung reflektiert werden, sowie optische Komponenten 7 für die Umlenkung und Umformung der Sendelichtstrahlen 13 und Empfangslichtstrahlen 12 vorgesehen. Das Empfangssignal wird dann beispielsweise durch eine Distanz- und/oder Amplitudenmesseinheit ausgewertet. Ausserdem ist eine Steuereinheit 9 für den Laserscanner 1' im Gehäuse 5 vorgesehen, ebenfalls durch gestrichelte Linien angedeutet, welche bei einem Scanvorgang die Rotation der Rotationseinheit 10 um die Zylinderachse 11 und die Drehung des Gehäuses 5 um die Basisachse 4 koordiniert.

Im Betriebszustand des Laserscanners 1' wird ein von der Lichtquelle 6 erzeugter, in der Regel gepulster Sendelichtstrahl 13 durch die optischen Komponenten 7 kollimiert und auf den Rotationsspiegel 22 gelenkt, dort umgelenkt und in die Umgebung ausgesandt. Von einem Objekt in der Umgebung reflektierte oder sonst gestreute Empfangslichtstrahlen 12 werden vom Rotationsspiegel 22 wieder eingefangen, umgelenkt und durch die optischen Komponenten gebündelt und dann auf den photosensitiven Detektor 8 weitergeleitet. Die Richtung des Sendelichtstrahls 13 in die Umgebung und der Einfallswinkel für Empfangslichtstrahlen 12 auf den Rotationsspiegel ergeben sich aus den Winkelstellungen der Rotationseinheit 10 bezüglich der Zylinderachse 11 und der Basisachse 4, welche von den Stellungen ihrer jeweiligen Drehantriebe abhängen. Diese Stellungen können dabei - wie dies an sich bekannt ist - von zugeordneten Winkelencodern erfasst werden (hier der Einfachheit halber nicht dargestellt).

Für die Koordinaten zur Darstellung einer Punktwolke sind die Winkelstellungen der Richtung des Sendelichtstrahls 13 zum Zeitpunkt des Aussendens relevant. Die Winkelstellungen der den Objekten zugeordneten Empfangslichtstrahlen 12 waren bisher erst nach erfolgter Distanzberechnung bekannt. Mit der erfindungsgemässen segmentierten APD kann aber bereits aus der Parallelisierung der Signale und der zeitlichen Signalverteilung unter den wenigstens 2 Kanälen Information über die Grobdistanzen, auch von Mehrfachzielen, abgeleitet werden.

Mittels der (schnellen) Drehung des Rotationsspiegels 22 um die Zylinderachse 11, beispielsweise mit einer Rotationsgeschwindigkeit zwischen 50Hz und 250Hz, wird entlang einer Kreislinie in einer vertikalen Ebene die Umgebung optisch abgetastet. Mittels einer (im Vergleich dazu langsamen) Drehung um die Basisachse 4 wird mit den Kreislinien sukzessive der gesamte Raum abgetastet. Aus der Gesamtheit der Messpunkte einer solchen Messung ergibt sich ein Voll-Scan des die Vorrichtung umgebenden Raums. Je nach Art der Auswertung kann aus dem Scan z.B. eine 3D-Punktwolke oder bei gleichzeitiger Detektion der empfangenen Lichtintensitäten z.B. eine photographieähnliche Darstellung der gescannten Umgebung resultieren.

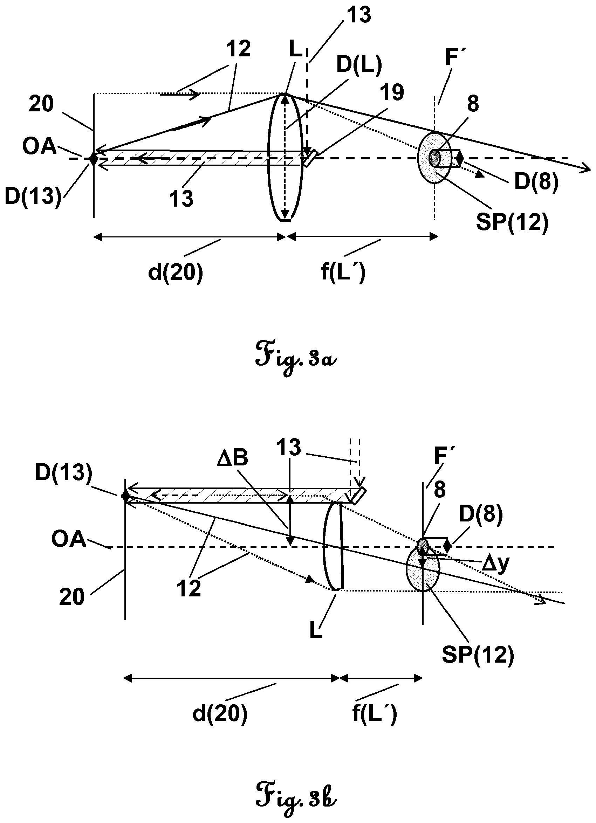

Fig. 3a illustriert die Ausleuchtung einer APD mit einem Durchmesser D(8) als Detektor 8 bei koaxialer Anordnung von Sender und Empfänger, also von Sendelichtstrahlen 13 und Empfangslichtstrahlen 12. Das Sendelicht 13 einer Lichtquelle, insbesondere Laserlicht, wird über einen (üblicherweise rotierenden) Spiegel 19 in Richtung eines Zielobjekts 20 umgelenkt.

Der Durchmesser des Empfangslichtbündels nimmt mit abnehmender Distanz d(20) zwischen Objekt 20 und Sammeloptik L, welche einen Durchmesser D(L) aufweist, zu. In der Regel existiert eine zentrale Abschattung oder eine kreisförmige zentrale Zone mit Durchmesser D(13) um die optische Achse OA, bei der das Empfangslicht 13 fehlt oder schwächer ist als im ringförmigen Aussenbereich des Strahlungsbündels. Diese zentrale Abschattung nimmt ebenfalls im Durchmesser mit kürzer werdender Objektdistanz d(20) zu.

Eine erste (empfängerseitige) radiometrische Grenzdistanz, nachfolgend auch abgekürzt mit "d1", ist definiert durch diejenige Distanz, bei der der Durchmesser des Strahlungsbündels gleich gross ist wie die Nahfeldblende. Die Nahfeldblende ist üblicherweise entweder durch die Detektorfläche, eine Blendenmaske oder den Kern eines Empfangslichtleiters definiert. Ab der Distanz d1 nimmt das zugehörige Signal des APD-Detektors 8, der in einem Bildabstand f(L') von der Sammeloptik L angeordnet ist und auf den in der Bildebene F', in welcher der Detektor 8 positioniert ist, ein Empfangslichtspot SP(12) fällt, mit weiter abnehmender Distanz nicht mehr zu.

Eine zweite (empfängerseitige) radiometrische Grenzdistanz, nachfolgend auch abgekürzt mit "d1m", ist gegeben durch diejenige Distanz, bei der die zentrale Abschattung des Senders die Nahfeldblende vollkommen abdeckt. Ab dieser und kürzeren Distanzen ist nur noch sehr wenig oder gar kein Signal mehr empfangbar.

Ein resultierendes Problem ist einerseits die quadratische Signalabnahme ab der Grenzdistanz d1, so dass bei grossen Distanzen die Signale sehr klein sind. Zudem werden sowohl stark als auch schwach reflektierende Objekte angemessen, was die Signalvariation zusätzlich erhöht. Die Empfangselektronik muss daher sehr grosse Signalunterschiede handhaben, welche in der Regel um einen Faktor 5000 oder mehr variieren können, was mit bisherigen Empfangselektroniken nur kaum erreichbar ist. Vor allem bei schnellen Messfolgen wie bei Scannern mit 1 Million Messpunkten pro Sekunde sind diverse bekannte Lösungen ungenügend oder sehr komplex und dadurch teuer.

Bekannte Lösungen sind:

- Bei langsamen Messfolgen mit Messfrequenzen kleiner als 100 Hz, wie beispielsweise bei Theodoliten üblich, wird ein motorisch angetriebenes Graukeilrad bewegt, sodass das optische Empfangssignal optimal auf den Arbeitspunkt der Empfangselektronik eingestellt ist.

- Bei Messfolgen mit Messfrequenzen im Kilohertz-Bereich wird nach einer Probemessung, aus welcher die Signalamplitude abgeleitet wird, der APD-Gain (APD-Verstärkung) entsprechend eingestellt, damit das Empfangssignal im Aussteuerbereich der Empfangsschaltung liegt. Auch sind faseroptische Abschwächer, die nach der MEMS-Technologie aufgebaut sind, als einstellbare Abschwächer bekannt.

- Bei noch schnelleren Messpunktfolgen mit Messfrequenzen im Megahertz-Bereich bieten sich sogenannte "variable optical Attenuators" (VOA) an. Diese VOA basieren auf elektrooptischen Kristallen und können im Nanosekundenbereich geschaltet werden. Bisher sind solche Bauteile sehr teuer und benötigen zudem eine anspruchsvolle Ansteuerelektronik.

- Des Weiteren bekannt sind einstellbare Transimpedanz-Schaltungen. Diese Transimpedanz-Schaltungen sind den APDs oder den PIN-Dioden nachgeschaltet, und ermöglichen eine Anpassung der Signalverstärkung im Analogpfad. Alternativ kann auch nach der Transimpedanz-Stufe ein einstellbarer Spannungsverstärker platziert sein (variable gain amplifier, VGA). Solche elektrisch einstellbare Verstärker haben den Nachteil, dass ihre Laufzeit von der eingestellten Verstärkung abhängt, und sich die zugeordneten Kennlinien zumindest über die Temperatur verändern. Für genaue Messungen im Millimeter- oder Submillimeter-Bereich sind solche Schaltungen eher ungeeignet.

- Es gibt Distanzmessvorrichtungen, die logarithmisch arbeitende Verstärkerelemente im Empfangssignalpfad haben. Diese haben aber oft den Nachteil, dass die Signalform verzerrt und dadurch eine genaue Laufzeitbestimmung sehr aufwendig wird. Insbesondere störend und kaum erfassbar sind zusätzliche Einschalt-Drifts, die thermisch bedingte Phasenverschiebungen erzeugen. Bisher sind keine Instrumente bekannt, die eine absolute Messgenauigkeit von einem Millimeter oder genauer aufweisen.

Fig. 3b zeigt die Ausleuchtung einer APD bei biaxialer Anordnung von Sender und Empfänger, also von Sendelichtstrahlen 13 und Empfangslichtstrahlen 12, wobei hier ein biaxialer Versatz ∆B vorliegt.

Wie bei der für Fig. 3a zugrunde liegenden nimmt auch hier der Durchmesser des Empfangsbündels mit abnehmender Distanz d(20) zu. Gleichzeitig verschiebt sich aber die Mitte des Lichtflecks / Empfangslichtspots SP(12) von der optischen Achse OA weg zur Seite, um einen Versatz ∆y. - Der Versatz ∆y ergibt sich aus dem biaxialen Versatz ∆B wie folgt:

$$\Delta y \ = \ (f(L') \times \ \Delta B \ / \ d(20)$$

Dieser aus der biaxialen Anordnung resultierende Versatz ∆y hat den Nachteil, dass bei kurzen Distanzen kein Licht mehr auf die Empfangsdiode 8 fällt.

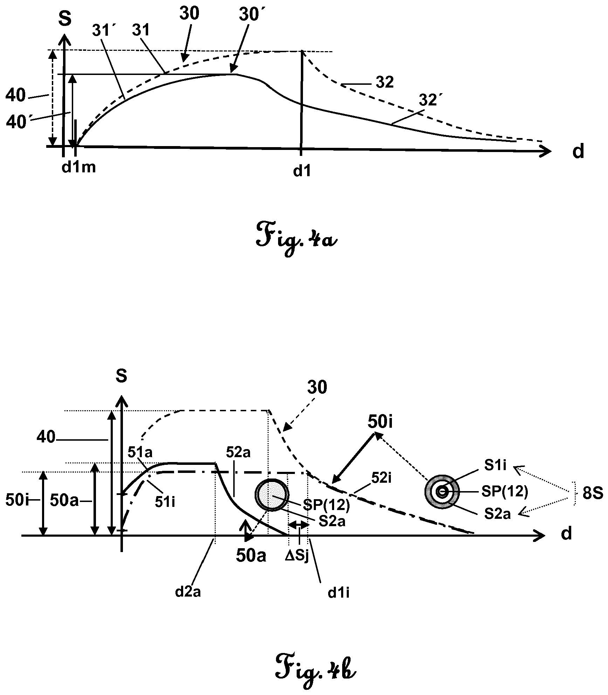

Fig. 4a zeigt die Signalvariation als Funktion der Distanz mit einer einfachen, nicht segmentierten APD nach dem Stand der Technik für zwei verschiedene Positionen der APD im Empfangsstrahlengang, nämlich, entsprechend der gestrichelten Kurve, in der Brennebene mit zugehörigem Kurvenverlauf 30 und, entsprechend der durchgezogenen Kurve, zwischen der Sammeloptik (Objektiv) und der Brennebene des Objektivs mit zugehörigem Kurvenverlauf 30'.

Bei der unsegmentierten APD nach dem Stand der Technik ist die Signaldynamik durch zwei charakteristische Distanzen gekennzeichnet. Von langen Objektdistanzen kommend (entsprechend den Kurvenabschnitten 32 bzw. 32') nimmt das Signal mit abnehmender Distanz quadratisch zu, und zwar bis zu einer radiometrischen Grenzdistanz d1. Bei kürzeren Distanzen als d1 bleibt das Signal zunächst annähernd konstant, bei noch kürzeren Distanzen nimmt das Signal wegen Abschattungsproblemen wieder ab (entsprechend den Kurvenabschnitten 31 bzw. 31'). Bei Distanzen kürzer als eine zweite charakteristische Distanz d1m ist das Signal oft zu niedrig, um zuverlässige oder rauscharme Messungen liefern zu können.

Problematisch wirkt sich dabei auch die erforderliche hohe Signaldynamik für den abzudeckenden Distanzbereich aus, woraus hohe Anforderungen an die Qualität der APD und die Signalverarbeitungselektronik resultieren. Der sehr grosse Bereich 40 der Signaldynamik für den Kurvenverlauf 30, mit Positionierung der APD in der Brennebene, wird durch Verlagerung der APD in eine Position zwischen Brennebene und Sammeloptik nur geringfügig auf einen Signalbereich 40' verringert.

Mittels eines weiteren unabhängigen APD-Segments, wie es von der vorliegenden Erfindung bereit gestellt wird (siehe im Folgenden), könnte zusätzlich Licht empfangen werden bei gleichzeitiger Verringerung der erforderlichen Signaldynamik eines einzelnen APD-Segments, und die Distanzmessung wäre von verbesserter Güte.

Fig. 4b illustriert die Signalvariation als Funktion der Distanz für eine erfindungsgemässe segmentierte APD 8S, im Vergleich zum Signalverlauf 30 der unsegmentierten APD gemäss Fig. 4a.

Für eine erste Ausführungsform einer erfindungsgemässen APD 8S mit wenigstens zwei unabhängigen Segmenten S1i und S2a sind die den einzelnen Segmenten S1i und S2a zugeordneten Signale eingezeichnet und mit dem Signal einer einteiligen APD gemäss der Darstellung von Fig. 4a verglichen. Dabei handelt es sich gemäss dieses Beispiels um eine segmentierte APD 8S mit zwei konzentrisch angeordneten und zueinander beabstandeten Segmenten S1i und S2a, nämlich einem inneren, kreisförmigen Segment S1i für eine Bestimmung von relativ grossen Entfernungen und einem äusseren, ringförmigen Segment S2a für eine Bestimmung von relativ kleinen Entfernungen.

Die einzelnen Signalverlaufskurven, nämlich 50i für das innere APD-Segment und 50a für das äussere APD-Segment, sind qualitativ den Kurvenverläufen 30 bzw. 30' für die unsegmentierte APD ähnlich. Von grossen Distanzen kommend nimmt, gemäss den Kurvenabschnitten 52i bzw. 52a, das Signal zunächst wiederum mit abnehmender Distanz quadratisch zu, nämlich bis zu einem ersten Maximalwert entsprechend einer Signaldynamik 50i für das innere Segment S1i bei einer Grenzdistanz d1i und bis zu einem zweiten Maximalwert entsprechend einer Signaldynamik 50a für das äussere Segment S2a bei einer Grenzdistanz d2a, wobei d2a < d1i.

Der Distanzbereich ΔSj ist ausgezeichnet durch die Konstanz des Signals des inneren APD-Segments (da bei kleiner werdenden Distanzen ab der Distanz d1i dieses innere Segment vollständig vom zurückkommenden Lichtstrahl abgedeckt wird und die Energie pro Fläche des zurückkommenden Lichtstrahls ja auch bei kürzer werdenden Distanzen nicht weiter zunimmt, sondern der Durchmesser). Das innere Segment übersättigt also im Distanzbereich ΔSj bzw. noch kürzer werdenden Distanzen nicht, da das Empfangssignal nicht weiter anwächst. Das äussere Segment empfängt hier im Bereich ΔSj noch kein Signal (wird hier also vom zurückkommenden Lichtstrahl noch nicht abgedeckt, sondern erst wieder bei noch kürzeren Distanzen). Dieser Bereich ΔSj wird massgeblich durch den Abstand zwischen den beiden Segmenten S1i und S2a bestimmt. Durch einen geeigneten Abstand der beiden APD-Segmente kann die Grösse des Distanzintervalls ΔSj dimensioniert werden. Es ist dabei darauf zu achten, dass bei noch kürzeren Distanzen das Signal des äusseren APD-Segments ein hohes SignalRauschverhältnis erreicht hat bevor das Signal des inneren APD-Segments wegen einer Abschattung bei kurzen Distanzen unbrauchbar klein geworden ist.

Die Figur verdeutlicht, dass bereits bei einer zweisegmentigen APD 8S mit unterschiedlicher Signal-Verstärkung der zugeordneten Kanälen die Reduktion der Signaldynamik als Funktion der Distanz erheblich ist, nämlich von einer Signaldynamik 40 für die unsegmentierte APD auf 50a bzw. 50i für die beiden Segmente der erfindungsgemässen segmentierten APD 8S.

Zudem ist auch ersichtlich, dass der Signaleinbruch (von dem äusseren APD-Segment S2a) bei kurzen Distanzen kleiner ausfällt. Dies wird erreicht beispielsweise, wenn die zweisegmentige APD ein inneres Element von $100 \mu m$ und ein äusseres Element von $300 \mu m$ Durchmesser hat im Vergleich zu einer ein-segmentigen $200 \mu m$ grossen APD. Mit drei Segmenten wäre die Signalglättung über die Distanz noch feiner dimensionierbar.

Die Erfindung löst daher nicht nur das Problem der Signaldynamik, sondern kann auch als Massnahme zur Signalanhebung im Nahbereich bei kürzesten Distanzen verwendet werden. Insbesondere kann also wenigstens ein Empfangssegment so dimensioniert und angeordnet sein, dass ein von einem im Nahbereich, insbesondere < 5m, befindlichen Zielobjekt zurückgestreutes Lichtsignal mit - in einer Empfangsebene betrachtet - einem Strahlquerschnitt mit vglw. grossem Durchmesser und vglw. grosser zentraler Abschattung empfangbar ist, insbesondere wobei das Empfangssegment kreisringförmig oder kreisringsegmentförmig ausgebildet ist und einen Aussenkreisdurchmesser von mindestens $200 \mu m$ oder $300 \mu m$ aufweist, im Speziellen von mindestens $500 \mu m$. Mittels geeigneter Gestaltung der Sensorflächen (also so, dass auch mind. ein Segment genau dort in der Empfangsebene platziert wird, wo die Lichtsignale von in kürzesten Distanzen befindlichen Objekten hin zurückgestreut werden) können potentielle Probleme sowohl durch die zentrale Abschattung bei koaxialen Systemen als auch die Translation des Lichtflecks SP(12) bei biaxialen Optiken gelöst werden.

Umgebungslicht oder Hintergrundlicht ist hauptsächlich störend bei schwachen Signalen, insbesondere bei grossen Distanzen. Der durch Umgebungslicht erzeugte Photostrom erzeugt Schrotrauschen, was das Messergebnis verschlechtert. Einerseits wird durch die Unterteilung der APD in mehrere unabhängige Segmente auch der Beitrag des Hintergrundlichts aufgeteilt. Der störende Einfluss des Schrotrauschens reduziert sich mit der Quadratwurzel der Entfernung. Andererseits kann das der längsten Distanz zugeordnete APD-Segment, hier S1i, entsprechend kleiner ausgelegt werden. Damit wird der Einfluss des Schrotrauschens bei grossen Distanzen zusätzlich reduziert.

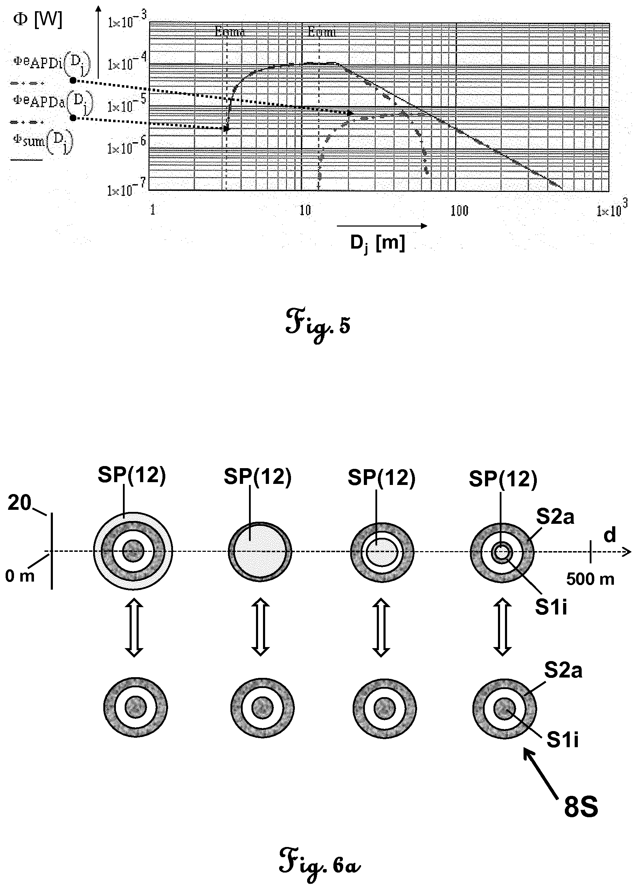

Fig. 5 zeigt einen beispielhaften Signalverlauf von einer erfindungsgemässen zweisegmentigen APD als Funktion der Distanz $D_j$ zu einem Zielobjekt. Dargestellt sind dabei die optischen Empfangsleistungen $\Phi eAPDi(D_j)$ für ein inneres Segment und $\Phi eAPDa(D_j)$ für ein äusseres Segment sowie die Summe $\Phi sum(D_j)$ der Empfangsleistungen von den beiden APD-Segmenten.

In dem dargestellten Entfernungsmessbereich verzeichnet das äussere APD-Segment ein, wenn auch zunächst noch geringes, Empfangssignal ab einer Grenzdistanz von etwa 3 m, wobei das Signal dann mit zunehmender Entfernung bis zu einer Distanz von etwa 8 m stark zunimmt, bis zu einem oberen Grenzwert von ca. $1 \times 10^{-4}$ W, dann bis zu einer Entfernung von etwa 25 m auf diesem oberen Grenzwert verharrt, bis es danach dann mit weiter steigender Entfernung wieder immer stärker abfällt, wenn also offensichtlich der Empfanglichtspot zu klein ist, um das äussere APD-Segment noch zu erreichen. Demgegenüber steigt das Signal des inneren APD-Segments von faktisch Null erst ab einer Grenzdistanz von etwa 12 m mit zunehmender Entfernung stark an und erreicht bei etwa 40 m einen Grenzwert (ca. $6 \times 10^{-5}$ W), von dem es dann mit weiter zunehmender Entfernung wesentlich langsamer zurückgeht.

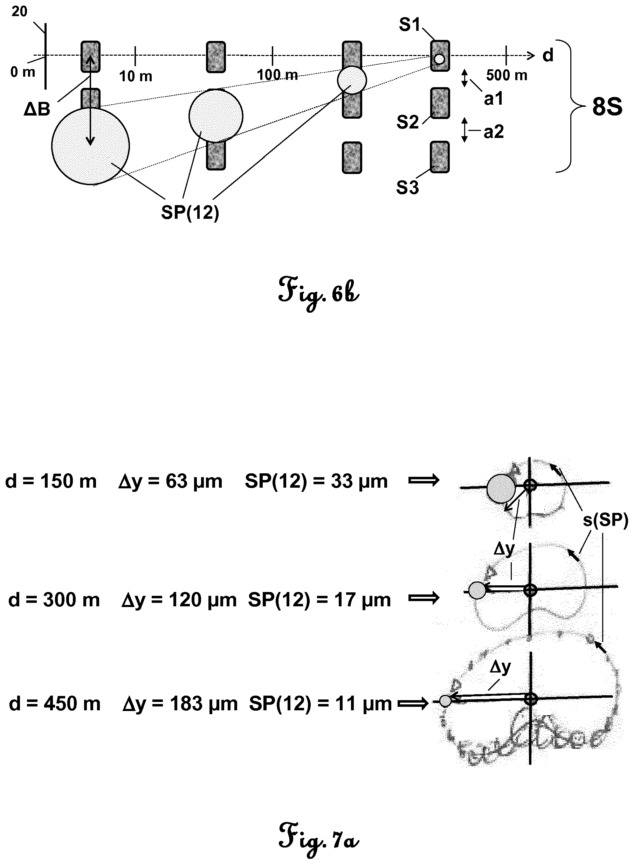

Erfindungsgemäss wird die neue APD in mehrere unabhängige Segmente aufgeteilt, wie nachfolgend Fig. 6a für eine koaxiale Anordnung von Sender und Empfänger, und Fig. 6b, für eine biaxiale Anordnung von Sender und Empfänger, beispielhaft dargestellt.

Dabei wird der erfindungsgemässe Detektor so aufgeteilt bzw. die erfindungsgemässe APD 8S so segmentiert, dass bei grossen Distanzen bis zu einer ersten zu definierenden Grenzdistanz der gesamte Lichtfleck SP(12) auf ein innerstes Segment S1i fällt. Bei geringeren Distanzen als dieser ersten Grenzdistanz ist der Lichtfleck SP(12) grösser als die erste Empfangsfläche S1i, und ein mit weiter kürzer werdender Distanz zunehmender Teil des Lichtflecks SP(12) wird mit diesem ersten Segment S1i nicht mehr empfangen. Dieses bedeutet, dass das Empfangssignal bei grösseren Distanzen als dieser ersten Grenzdistanz das Signal des innersten Segments S1i nicht mehr zunimmt. Die Signaldynamik wird damit begrenzt.

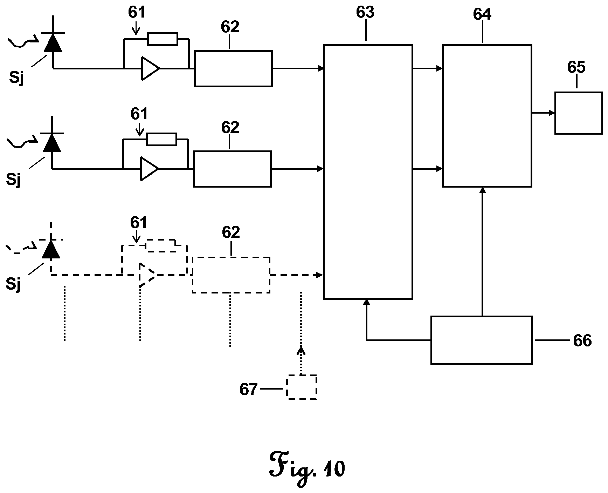

Jedem unabhängigen APD-Sensorelement ist eine eigene Empfangsschaltung zugewiesen, wie später in Fig. 10 illustriert. Das Empfangssignal und damit die Signaldynamik werden dadurch aufgeteilt. Damit die Signaldynamik nicht nur additiv, sondern multiplikativ reduziert wird, sind die einzelnen Signalpfade mit unterschiedlicher Signalverstärkung ausgebildet. Beispielsweise ist die Verstärkung eines zweiten Segments für mittlere bis kurze Distanzen mit einer zehnmal kleineren Verstärkung versehen.

Um auch im Nahbereich die Empfangsströme nicht unverhältnismässig ansteigen zu lassen, kann das äussere APD-Segment auch zweiteilig bestehend aus zwei halbkreisförmigen Ringsegmenten ausgebildet sein, sodass die Fläche der beiden äusseren Segmente derjenigen des inneren Segments entspricht.

Fig. 6a illustriert eine erste Ausführungsform einer segmentierten Avalanche-Photodiode APD 8S, als Beispiel für einen erfindungsgemässen Detektor, und ihren Einsatz in einer koaxialen Anordnung von Sender und Empfänger bei unterschiedlichen Distanzen vom Zielobjekt zur APD 8S.

Die beispielhaft dargestellte segmentierte APD 8S in Fig. 6a besteht aus zwei Segmenten S1i und S2a, wobei jedem Segment ein Distanzbereich zum Objekt 20, hier schematisch angedeutet durch Randdistanzen von 0 m und 500 m, zugeordnet ist. Jedes APD-Segment S1i, S2a trägt jeweils einen Teil der gesamten erforderlichen Signaldynamik bei, welche sich sonst aus dem gesamten abzudeckenden Distanzbereich ergeben würde. Die Flächen der APD-Segmente S1i und S2a sind gemäss diesem Ausführungsbeispiel wie folgt ausgebildet:

- Ein innerstes APD-Segment S1i ist eine Kreisfläche und sammelt optische Strahlung bei längsten und bei mittleren Distanzen. Bei Distanzen kürzer als eine erste (weite) Grenzdistanz, bei der der Lichtfleck die Grösse der Sensorfläche des innersten APD-Segments erreicht hat, nimmt das Signal nicht mehr zu (auch wenn der Strahlquerschnitt dann bei näher liegenden Distanzen natürlich noch weiter wächst). Ab einer weiteren Grenzdistanz wird das Empfangslichtbündel durch eine zentrale Abschattung im Bereich der optischen Achse geschwächt, sodass dann das Empfangssignal bei kürzer werdenden Distanzen also wieder abnimmt, da durch die zentrale Abschattung wieder weniger Licht auf das innerste APD-Segment fällt.

- Das zweite APD-Segment S2a ist eine Ringfläche und detektiert optische Strahlung ab mittleren bis zu kurzen Distanzen. Diese Ringfläche wird vom Lichtbündel also nur im Falle dieses Distanzbereichs getroffen. Da im Nahbereich wegen des quadratischen Abstandsgesetzes die Signalstärke eher hoch ist, kann die diesem APD-Segment zugeordnete elektronische Verstärkung kleiner sein als die des zentralen APD-Segments. Damit kann die Signaldynamik am Ausgang vorteilhaft reduziert werden.

- Bei ganz kurzen Distanzen ist die zentrale Abschattung grösser als die APD-Ringfläche. Um trotzdem bei ganz kurzen Distanzen noch Licht zu empfangen, kann ein drittes ringförmiges APD-Segment hinzugefügt werden. Auch kann das zweite Ringelement einen grösseren Aussendurchmesser aufweisen als der einer Standard-APD, damit aber die Fläche dieses APD-Segments nicht störend gross wird, kann anstelle der ringförmigen Form auch eine polare Segmentierung bestehend aus Winkelsektoren aufweisen.

Fig. 6b illustriert eine zweite Ausführungsform einer segmentierten Avalanche-Photodiode APD 8S, als Beispiel für einen erfindungsgemässen Detektor, und ihren Einsatz in einer biaxialen Anordnung von Sender und Empfänger bei unterschiedlichen Distanzen d vom Zielobjekt zur APD 8S.

Bei biaxial angeordneten optischen Systemen ist eine asymmetrische Anordnung der unabhängigen APD-Segmente, hier S1, S2 und S3, vorteilhaft. In dieser Darstellung sind APD-Segmente gleicher Fläche abgebildet, damit sind die maximalen Photoströme von ähnlicher Amplitude. APD-Segmente mit gleicher Räche haben zudem den Vorteil, dass die Segmente gleiche Ladungskapazitäten aufweisen. Dadurch sind die Anstiegszeiten der elektrischen Ströme gleich gross, was die Signalverarbeitung vereinfacht.

Da die APD-Segmente dedizierten, d.h. vordefinierten oder vordefinierbaren, Distanzbereichen zugeordnet sind, ist ein erfindungsgemässer APD-Empfänger 8S bzw. -Detektor mit unabhängigen Segmenten und Signalpfaden auch für eine Eindeutigkeitslösung bei einer Entfernungsbestimmung vorteilhaft.

Unter der "Eindeutigkeitslösung" wird dabei folgendes verstanden: Es muss die Anzahl der Pulse, welche sich gleichzeitig in der Luft befinden, bestimmt werden. Andernfalls kann die Distanz nicht eindeutig berechnet werden. Ist die Laserschussrate grösser als das Inverse der Lichtlaufzeit über die zu vermessende Distanz, so befindet sich mehr als ein Lichtpuls zwischen Sender und Empfänger. Bisherige Methoden basieren auf seit Jahrzehnten bekannten Signalmodulationen. Vielfach werden Phasen- oder Intervallmodulation (PSK), Frequenzmodulation (FSK), Amplitudenmodulation (ASK), Polarisationsmodulation oder Wellenlängenkodierungen eingesetzt.

Mit den Signalen der einzelnen APD-Segmente kann vorteilhaft jedoch eine Grobdistanzschätzung vorgenommen werden. Erscheint ein Impuls bzw. Empfangslichtspot SP(12) nur auf dem innersten Segment S1, so muss die Objektdistanz d gleich oder grösser als die dem Segment S1 zugeordnete Distanz sein. Erscheint hingegen ein Impuls SP(12) gleichzeitig auf dem innersten Segment S1 und dem benachbarten Segment S2, so muss die Objektdistanz in einem Intervall zwischen 0 m und einem möglichen Zwischendistanzbereich zu der dem Segment S1 zugeordneten Distanz sein.

Bei mehreren Segmenten lässt sich die Unterteilung der Distanzintervalle weiter führen und/oder verfeinern. Dabei können - je nach abzudeckendem Distanzbereich - Abstände a1, a2, ... zwischen aufeinander folgenden Segmenten S1, S2, S3 etc. einheitlich oder auch unterschiedlich sein.

Bei dem in Fig. 6b dargestellten, nicht massstäblichen Beispiel deckt ein Empfangslichtspot SP(12) bei einer Objektentfernung von etwa 5 m das äussere Segment S3 vollständig und das mittlere Segment S2 teilweise, etwa zur Hälfte, ab. Bei einer Objektentfernung von etwa 30 m deckt ein entsprechender Empfangslichtspot SP(12) das mittlere Segment S2 vollständig und das äussere Segment S3 noch zu einem geringen Teil ab. Bei einer Objektentfernung von etwa 150 m deckt ein entsprechender Empfangslichtspot SP(12) die einander gegenüber liegenden Randbereiche der Segmente S1 und S2 ab, und bei einer Objektentfernung von etwa 400 m füllt ein entsprechender Empfangslichtspots SP(12) nur noch einen geringen Teil des innersten Segments S3. - Selbstverständlich ist diese Figur nur als rein illustrativ zu Beispielszwecken zu verstehen.

Fig. 7a zeigt eine Illustration der Lichtverteilung in der Empfangslichtebene bei Scanning, d.h. unter Verwendung eines rotierenden Spiegels, für eine koaxiale Anordnung von Sender und Empfänger.

Bei einem bewegten Messstrahl, wie beispielsweise im Fall eines terrestrischen Scanners oder von atmosphärischem LIDAR, kann sich der Lichtfleck in der Fokalebene einer Empfangsoptik seitlich zur optischen Achse verschieben. Dieses verkompliziert die Anordnung der unabhängigen APD-Segmente.

Eine Tabelle in Fig 7a zeigt in einem Beispiel, von welcher Grössenordnung diese Abweichungen von der optischen Achse sind und wie eine Bewegung s(SP) des Lichtflecks in der Detektionsebene eines koaxialen Sender-/Empfängersystems bei verschiedenen Objektdistanzen d aussieht.

Die laterale oder radiale Auslenkung $\Delta y$ des Schwerpunkts des Empfangslichtbündels in der Fokalebene eines Empfangsobjektivs berechnet sich wie folgt:

$$\Delta y := fe \cdot \frac{4\pi}{co} \cdot f_{rot} \cdot Dist$$

Dabei bedeuten "fe" die effektive Empfängerbrennweite, "co" die Lichtgeschwindigkeit, "$f_{rot}$" die Rotationsgeschwindigkeit des schnell rotierenden Spiegels und "Dist" die Distanz zum Zielobjekt.

Der Durchmesser $Dia_{spot}$ des Lichtflecks auf der Fokalebene des Empfängers beträgt:

$$Dia_{spot} := \frac{fe \cdot de}{Dist}$$

Dabei steht "de" für den Pupillendurchmesser des optischen Empfangssystems.

Im Nahbereich ist der Lichtfleckdurchmesser erheblich grösser als die zur Drehspiegel synchrone radiale Bewegungsauslenkung. Jedoch ab einer genügend grossen Objektdistanz beschreibt der sich zum Drehspiegel synchron bewegende Lichtfleck eine eindeutig sichtbare Bahn. Diese stellt eine geschlossene Bahn dar, die dem jeweiligen Scanprofil entspricht.

Beispielsweise ist die Bahn des Lichtflecks bereits sichtbar, falls die dynamische radiale Verschiebung $\Delta y$ des Lichtflecks mindestens der Hälfte seines Durchmessers SP(12) entspricht.

Damit berechnet sich diese minimale Distanz "$Dist_{dyn}$" zum Zielobjekt bei einer konstenten Spiegeldrehfrequenz "frot" zu:

$$Dist_{dyn} = \sqrt{\frac{co \cdot de}{8\pi \cdot f_{rot}}}$$

Ab der Distanz "$Dist_{dyn}$" ist in der Detektionsebene eine Bahn des Lichtflecks beobachtbar. Folgendes numerisches Beispiel ist typisch für terrestrische Scanner:

$$de = 50 \text{ mm}, \quad f_{rot} = 50 \text{ Hz}, \quad co = 3 \times 10^{-8} \text{ m/s}$$

Damit beträgt $Dist_{dyn}$ 109 m.

Diese charakteristische Distanz $Dist_{dyn}$ mit einer eindeutig erkennbaren radialen Verschiebung ist ausreichend kurz, um bei Messraten von einer Million Messpunkten pro Sekunde die Eindeutigkeitsfrage mittels der Signalfrequenzen bzw. der Signaltaktrate der einzelnen den Segmenten zugeordneten Empfangssignalen ohne komplexen Algorithmus zu lösen; denn Scanner haben oft eine Laserschussrate oder Punktmessrate von einer Million Punkten pro Sekunde, was einen ersten Eindeutigkeitsbereich von 150 m ergibt und damit länger ist als $Dist_{dyn}$, was bedeutet, dass ab 150m die radiale Auslenkung und nicht mehr der Durchmesser des Lichtflecks dominiert, was die Auswertung der den APD-Segmenten zugeordneten Signalen erheblich vereinfacht (Ab einer Distanz von 150 m sind bei dieser Messfrequenz gleichzeitig zwei Pulse unterwegs, ab einer Distanz von 300 m drei Pulse, etc.). Die Grobdistanzschätzung der reflektierten Impulse kann bei schnell scannenden Laserstrahlen wie folgt geschehen:

- falls Signal auf äusserem APD-Segment dann grosse Distanz und damit zweiter Eindeutigkeitsbereich 150m..300m
- falls Signal auf innerem APD-Segment dann kurze Distanz und damit erster Eindeutigkeitsbereich 0m ..150m.

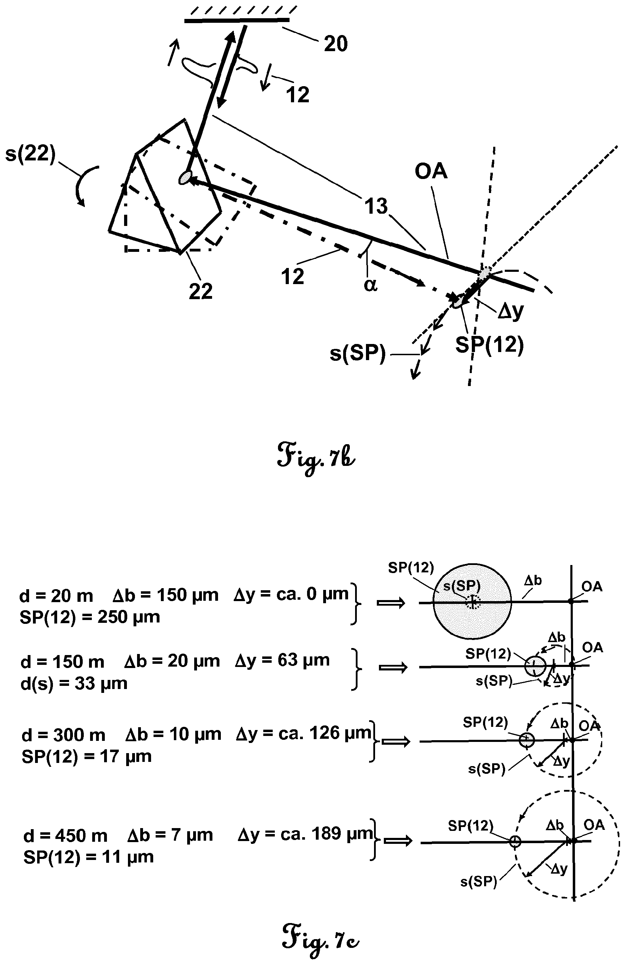

Fig. 7b zeigt eine Illustration, wie der reflektierte Empfangslichtstrahl 12 im Fall eines rotierenden Scanner-Spiegels 22 von der optischen Achse OA weggelenkt und dadurch eine radiale Verschiebung $\Delta y$ der Position des Empfangslichtspots SP(12) auf dem Detektor erzeugt wird.

Die Position des rotierenden Spiegels 22 ist für zwei verschiedene Zeitpunkte während der Spiegelrotation s(22) durch durchgezogene und gestrichelte Linien angedeutet. Dabei beziehen sich die durchgezogenen Linien auf den Zeitpunkt, an dem der Sendelichtstrahl 13 den Drehspiegel 22 trifft und von diesem zum Zielobjekt 22 umgelenkt wird. Bis das vom Zielobjekt 20 zurückkommende Empfangslicht 12 jedoch auf dem Drehspiegel 22 zurücktrifft, hat sich dieser um einen von der Rotationsgeschwindigkeit abhängigen Winkel weiter gedreht, so dass der vom Drehspiegel 22 umgelenkte Empfangsstrahl 12 nicht mehr am Auftreffpunkt entsprechend Lichtsignalen aus der optischen Achse, sondern radial verschoben um $\Delta y$ auf dem Detektor auftrifft.

Fig. 7c zeigt beispielhaft in einer zu Fig. 7a analogen Darstellung eine Illustration der Lichtverteilung, insbesondere der Lichtfleckgrössen SP(12) und radialen Verschiebungen $\Delta y$, in der Empfangslicht-Ebene bei Scanning, d.h. unter Verwendung eines rotierenden Spiegels 22, für eine biaxiale Anordnung von Sender und Empfänger, bei unterschiedlichen Distanzen zum Zielobjekt 20.

Auch bei biaxialen optischen Systemen ist ab einer ausreichend grossen Objektdistanz d eine Bewegung des Lichtflecks SP(12) eindeutig erkennbar. Die Bewegung stellt wiederum eine geschlossene Bahn s(SP) dar, die der vektoriellen Summe aus des Parallaxen-bedingten Versatzes und der Abweichung, d.h. der Weiterbewegung des Drehspiegels 22 um einen Winkel $\alpha$, während seiner Rotation, entspricht.

Da die Bewegung und die Grösse des Lichtflecks eindeutig beschreibbar sind, kann die optimale Auslegung der Anordnung und Form der APD-Segmente je nach Zielsetzung optimiert werden. Ist eine kleine Signaldynamik von höchster Priorität, so ist eine APD mit möglichst vielen kleinflächigen Segmenten vorteilhaft. Dieses ist auch vorteilhaft für die Reduktion des Einflusses des Sonnenlichts im Speziellen oder von Umgebungslicht im Allgemeinen. Soll hingegen die Eindeutigkeit (Ambiguity) ermittelt werden, so sind die verschiedenen Segmente der erfindungsgemässen APD auf die bei den Scannern nur wenigen, diskreten Stufen einstellbaren Spiegelgeschwindigkeiten (beispielsweise 25Hz, 50Hz, 100Hz) anzupassen.

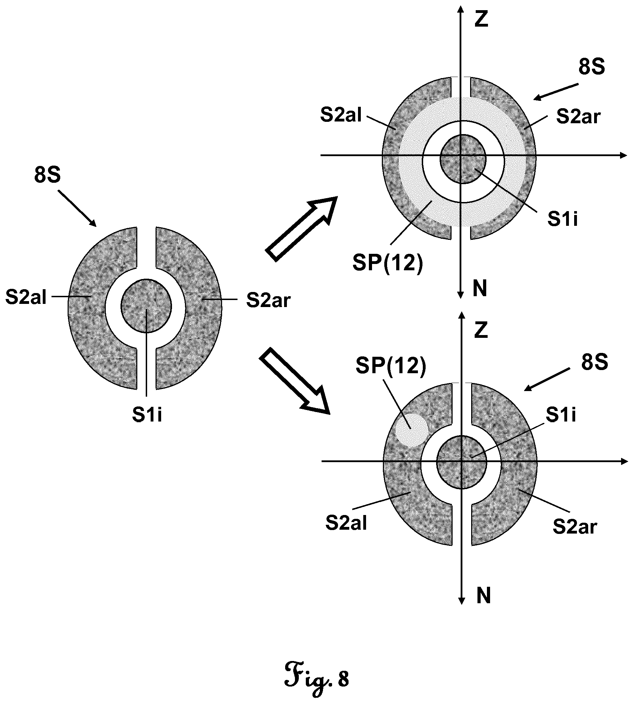

Fig. 8 zeigt eine weitere Ausführungsform einer erfindungsgemässen segmentierten APD 8S für einen Einsatz im Zusammenhang mit einem schnell drehenden Scanner-Spiegel. Der linke Teil der Abbildung illustriert diese aus drei Einzelsegmenten S1i, S2al und S2ar bestehende segmentierte APD 8S, mit einem inneren Segment S1i, einem (in dieser Darstellung) linksseitigen äusseren Segment S2al und einem weiteren (in dieser Darstellung) rechtsseitigen äusseren Segment S2ar.

Die beiden rechten Teilabbildungen verdeutlichen den Einsatz dieser segmentierten APD 8S bei zwei verschiedenen Anwendungssituationen. In den Diagrammen wird mit Z die Zenith-Richtung und mit N die Nadir-Richtung bezeichnet. Die obere Teilabbildung illustriert einen Fall bei kurzer Distanz zu einem Zielobjekt, wobei ein relativ grosser Empfangslichtspot SP(12) auf die APD 8S zurückreflektiert wird. Bei der hier zugrunde liegenden Anordnung wird eine zentrale Abschattung des Empfangslichts erzeugt. Daher fällt kein Licht auf das innere Segment S1i, während der Empfangslichtspot SP(12) Teile beider äusserer Segmente S2al und S2ar überdeckt. Die untere Teilabbildung illustriert eine Situation einer relativ grossen Distanz zum Zielobjekt, bei der ein relativ kleiner Empfangslichtspot SP(12) erzeugt wird, der nur auf das linke äussere Segment S2al fällt. Eine solche Situation ist insbesondere als repräsentativ und vorteilhaft für eine biaxiale Anordnung von Sender und Empfänger anzusehen. Die dargestellte Mess-Situation erleichtert eine Unterscheidung zwischen kurzen und grossen Distanzen zum Zielobjekt, was damit zumindest vorteilhaft für eine Lösung des bekannten Uneindeutigkeitsproblems ist, wenn gleichzeitig, d.h. innerhalb eines Mess-Takts, zwei Lichtpulse unterwegs zwischen Zielobjekt und Empfänger sind.

Eine Grobdistanzschätzung und damit eine Lösung der Eindeutigkeit werden durch die oben erläuterte Signalverteilung der APD-Segmente gegeben.

Es liegt z.B. eine sehr kurze Distanz vor falls die Signalstärken der Segmente sind wie:
S2al $\cong$ S2ar und S1i $\cong$ 0.

Es liegt eine mittlere Distanz vor falls die Signalstärken der Segmente sind wie:
S2al $\cong$ S2ar und S1i >> 0.

Es liegt eine lange Distanz vor falls die Signalstärken der Segmente sind wie:

S2al >>0, S2ar $\cong$ 0 und S1i $\cong$ 0 bei Scanwinkeln 0 bis 180° und

S2al $\cong$ 0, S2ar >>0 und S1i $\cong$ 0 bei Scanwinkeln 180 bis 360°.

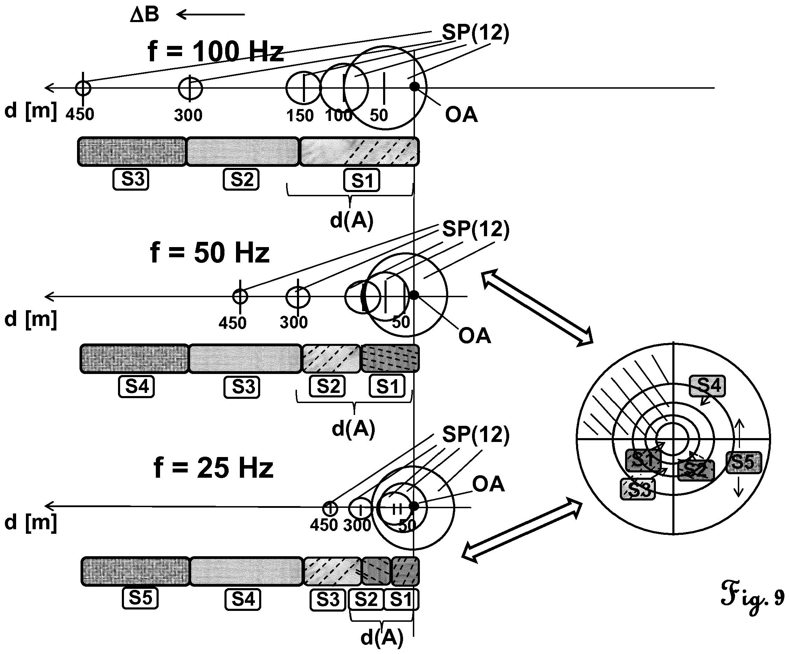

Fig. 9 zeigt eine Illustration einer erfindungsgemässen Problemlösung, insbesondere für Scanning mit einem rotierenden Scanner-Spiegel.

Bei Scanning mit einem schnell rotierenden Scanner-Spiegel ist die Eindeutigkeits-Lösung hinsichtlich des Anspruchs an ihre Erfüllung anspruchsvoller als bei Einsatz von quasistatischen Messstrahlen bzw. Sendelichtstrahlen. Figur 9 illustriert einen erfindungsgemässen Ansatz, wie eine passende APD-Segmentierung hergeleitet werden kann, insbesondere wenn das Eindeutigkeitsproblem gelöst werden soll.

Sowohl bei koaxialen als auch biaxialen optischen Systemen ist ab einer ausreichend grossen Distanz zum Zielobjekt eine Bewegung des Lichtflecks bzw. Empfangslichtspots SP(12) eindeutig erkennbar. Mittels einer geeigneten Segmentierung der APD-Sensorflächen soll die Eindeutigkeitsbestimmung ermittelt werden.

Unter jedem Scanwinkel (= Polarwinkel) ist es möglich, die Grösse und die Positionierung des Lichtflecks mit dieser APD-Segmentierung zu messen. Gemäss dieses Ausführungsbeispiels sind die Segmente S1, S2, S3, S4 und S5 so angeordnet, dass die Eindeutigkeit eines Empfangssignals für eine Distanzmessung mit einer Messfrequenz bei drei verschiedenen Rotationsgeschwindigkeiten des Scanner-Spiegels (entsprechend 25 Hz, 50 Hz und 100 Hz) bezüglich der schnellen Scan-Achse ermittelt werden kann. Vorteilhaft sind die fünf Segmente als Kreisringflächen ausgebildet. Falls die Flächen der äusseren Segmente bezüglich eines Einflusses von Umgebungslicht zu gross sind, können erfindungsgemäss diese Kreissegmente weiter, beispielsweise in Quadranten unterteilt werden.

Die Signaldynamik ist vornehmlich ein Problem für den Bereich von kurzen Distanzen. Diesen Distanzen zugeordnet sind in diesem Beispiel die inneren Segmente der erfindungsgemässen APD. Dieses gilt auch für sehr schnelle Scanspiegelbewegungen, da diese wegen der relativ kurzen Lichtlaufzeit zwischen Zielobjekt und Detektor keinen signifikanten resultierenden Versatz des Auftreffpunkts des Empfangssignals auf dem Detektor erzeugen. Eine feine Unterteilung, entsprechend der Darstellung von Fig. 9, in der Mitte der APD-Kreisstruktur ist daher ausreichend, um das Signal im Nahbereich auf mehr als ein APD-Segment aufzuteilen. Der Lichtfleck ist bereits bei mittleren Distanzen grösser als das innerste APD-Segment. Dadurch wird die radiometrische Grenzdistanz zu grösseren Distanzen hinaus verschoben und die Signaldynamik dadurch reduziert.

Fig. 10 zeigt ein Blockschaltbild für die Signalverarbeitung im Signalpfad eines erfindungsgemässen segmentierten Detektors bzw. einer erfindungsgemässen segmentierten APD, wobei die Signalwege für die Verarbeitung der Signale von zwei APD-Segmenten $S_j$ mittels durchgezogener Linien und der Signalweg von einem dritten APD-Segment $S_j$ mittels durchbrochener Linien angedeutet ist. Dabei ist ein zusätzlicher, von einem "Field Programmable Gate Array" FPGA 64 angesteuerter Multiplexer 67 ebenfalls angedeutet. Eine "Master Clock" 66 taktet den Analog-Digital-Wandler 63, der beispielsweise ausgebildet ist als ein "Multi Core ADC" oder "ADC-Bank", und den FGPA 64. Die Messdaten werden schliesslich vom FGPA 64 zu einer Datensicherung 65 übergeben.

Wird das Eindeutigkeitsproblem bei einer Distanzbestimmung wie bisher mittels senderseitiger Modulationsmethoden gelöst, können die einzelnen den APD-Segmenten $S_j$ zugeordneten Empfangskanäle mittels einer Multiplexer-Schaltung zusammengelegt werden. Als Schaltkriterium, welches Empfangssignal, jeweils nach Verstärkung durch einen Transimpedanz-Verstärker 61 und Durchgang durch einen Filter 62, bis zu einem Analog-Digital-Wandler (ADC) 63 durchgelassen wird, kann beispielsweise die Signalstärke benutzt werden. Der Signalpfad kann aber auch erstellt bzw. verbunden werden, sobald ein Signal eine vorgegeben Schwelle überschreitet und gleichzeitig dieses Signal dem kürzesten Distanzbereich zugeordnet ist. Alternativ kann der Signalpfad verbunden werden, sobald ein Signal eine vorgegebene Schwelle überschreitet und gleichzeitig dieses Signal dem längsten Distanzbereich zugeordnet ist. Eine weitere Möglichkeit der Signalführung ist ein permanentes Zusammenschalten der einzelnen den APD-Segmenten $S_j$ zugeordneten Empfangskanäle, wobei jeder der Kanäle vor dem Summationspunkt eine unterschiedliche Zeitverzögerung aufweist. Dadurch wird ein einziger Empfangsimpuls in mehrere aufgeteilt und zeitlich nacheinander einem Analog-Digital-Wandler (ADC) 63 zugeführt.

Im ersten Fall werden die Ziele erfasst und ausgewertet, welche das beste Signal-zu-Rausch-Verhältnis (SNR) bilden und daher die genauesten Distanzresultate oder Messpunkte liefern. Im zweiten Fall wird das erste Ziel angemessen ("first target detection"), und im dritten Fall werden solche Ziele, die am weitesten vom Detektor bzw. Empfangssegment $S_j$ entfernt aber noch gut messbar sind, angemessen ("last target detection").

In einem "Field Programmable Gate Array" FPGA 64 werden in Echtzeit, beispielsweise mit einer Frequenz von 2 MHz, die eintreffenden Signale abgearbeitet. Dabei wird nach Impulsen gesucht und werden die Amplituden und die Zeitpunkte der Signale von den APD-Segmenten $S_j$ auf Sub-Sampling-Genauigkeit bestimmt. Ausserdem werden diverse statistische Grössen wie beispielsweise Signalrauschen und Signal-zu-Rausch-Verhältnisse SNR berechnet. Erfindungsgemäss kann auch die Eindeutigkeit anhand der Signalmuster auf den verschiedenen Kanälen bestimmt werden. Beispielsweise ist die Spotgrösse korreliert mit der Distanz zu einem Zielobjekt. Auch der laterale Versatz des Empfangslichtspots auf dem Detektor, wenn der Scann-Spiegel mit entsprechender Geschwindigkeit verschwenkt wird, stellt ein Mass für die Distanz dar. Spotgrösse und/oder lateraler Versatz des Lichtflecks können mit Hilfe einer geeigneten Anordnung und Form der APD-Segmente ermittelt werden.

Die mehreren Empfangssignale können auch für eine Steigerung der Robustheit der Datenauswertung herangezogen werden, und zwar mittels Vergleichs-, Korrelations- oder Plausibilitätsprüfung von Distanzen, von Signalstärken oder von Pulsformen der den Kanälen zugeordneten Signale.

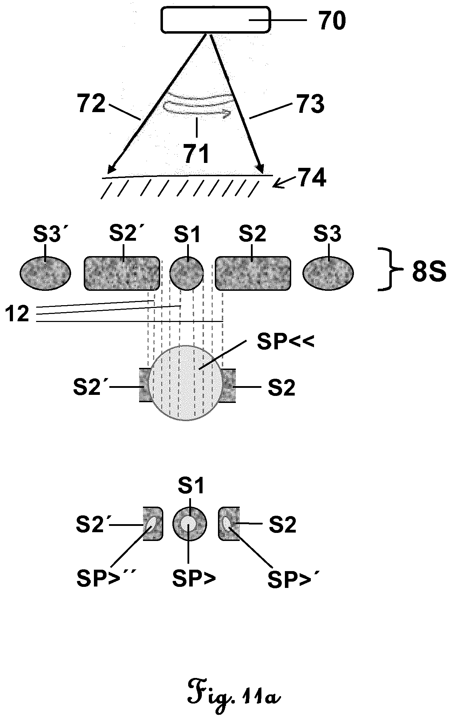

Fig. 11a zeigt eine Illustration einer Anwendung einer erfindungsgemässen segmentierten APD 8S bei LIDAR für eine Unterdrückung einer Detektion von Fehlsignalen, insbesondere infolge von Störungen durch Schwebeteilchen 71 durch Luftbewegungen, bei einer koaxialen Anordnung von Sender und Empfänger.

Vor allem bei sehr starken Lasern mit einer mittleren Sendeleistung von mehr als 1 Watt können Probleme durch Rückreflexion von luftgestützten Abtaststrahlen 72, 73 an Aerosolen 71 aber auch an Wolken und Staubpartikeln auftreten. Diese lichtstreuenden Schwebeteilchen können einen Fehltrigger, auch bezeichnet als "Luftziele", verursachen. Ist die Laufzeit von einem Luftfahrzeug 70 zum eigentlichen Ziel kürzer als das Laserpulsintervall, dann befindet sich lediglich ein einziger Lichtpuls in der Luft. Bei solchen Einstellungen kann der Empfänger blind beispielsweise auf den ersten 500 m für eine Distanz zu einem Zielobjekt (hier Boden 74) mittels Fenstertechnik inaktiv geschalten werden, so dass eine Detektion der "Luftziele" unterdrückt wird. Heutzutage ist die Laserschussrate jedoch viel höher. Damit befinden sich während eines Mess-Intervalls jeweils mehrere Impulse zwischen Sender und Empfänger, und da die Impulse jederzeit auf dem Empfänger eintreffen können, kann eine empfängerseitige Zeitfensterung, wie vorangehend beschrieben, nicht verwendet werden. Eine vergleichbare Problematik ist auch im Bergbau - insbesondere im Tagebergbau - bekannt, wo über mehrere Kilometer durch staubige Luft die Grubenhänge mittels LIDAR-Instrumenten überwacht werden.

Eine erfindungsgemässe segmentierte APD 8S ermöglicht eine Lösung dieses Problems. Bei koaxialen Systemen treffen Impulse, die den Aerosolen zuzuordnen sind, jeweils vorwiegend das innerste APD-Segment S1 und weniger weiter peripher angeordnete APD-Segmente S2, S2', S3 und S3'. Dadurch ist es möglich, Impulse aus kurzen Distanzen, beispielsweise aus bis zu 500 m scheinbarer Entfernung, zu identifizieren und auszublenden.

Der Kreis mit dem Referenzzeichen SP<< zeigt einen Lichtfleck erzeugt durch ein nahes Zielobjekt. Eine Grobdistanz kann abgeleitet werden durch eine Grössenabschätzung des Lichtflecks mittels eines Signalvergleichs der inneren drei APD-Segmente S1, S2, und S2'. Lichtflecke von grossen Distanzen SP>, SP>' und SP>" sind kleiner und bestrahlen vorwiegend nur ein einziges APD-Segment und können dadurch identifiziert werden.

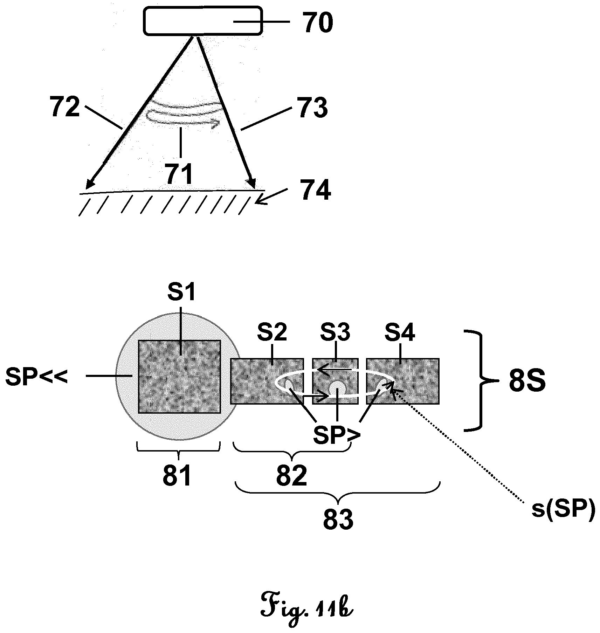

Fig. 11b zeigt eine zu Fig. 11a analoge Illustration einer Anwendung einer erfindungsgemässen segmentierten APD bei LIDAR für eine Unterdrückung einer Detektion von Fehlsignalen, insbesondere infolge von Störungen durch Schwebeteilchen bei Luftbewegungen, bei einer biaxialen Anordnung von Sender und Empfänger. Die optische Achse des Empfängers befindet sich beim APD-Segment S3. Um Objekte bei kurzen Distanzen zu empfangen ist ein erstes APD-Segment S1 vorgesehen, dieses ist so ausgelegt, dass die entsprechend grossen Empfangslichtspots SP<< aber auch gewollte Luftziele wie Rückstreuung an Wolken aus einem Abstand von weniger als 500m Entfernung (81) gemessen werden. Die weiteren drei APD-Segmente S2,S3 und S4 sind für Objektziele bei mittleren bis grösseren Distanzen als 500m vorgesehen, dabei oszilliert der Lichtfleck synchron zur Spiegelbewegung des Scanners über die drei APD-Segmente hinweg. Mit "s(SP)" ist dabei die Spur des Empfangslichtspots auf den Empfangssegmenten S2, S3 und S4 infolge der Bewegung des Scanner-Spiegels gekennzeichnet, wobei diese Segmente vorgesehen sind für mittlere Distanzen (beispielsweise die Segmente S2 und S3) und für grössere Distanzen (beispielsweise die Segmente S3 und S4). Bei mittleren Distanzen liegt die Spur des Empfangslichtspots vor allem im Bereich 82 und bei langen Distanzen im Bereich 83. Um den Einfluss von störendem Umgebungslicht zu reduzieren sind die Segmente, welche längeren Distanzen zugeordnet sind vorzugsweise von kleinerer Fläche als diese welche Signale aus kurzen Distanzen empfangen.

Es versteht sich, dass diese dargestellten Figuren nur mögliche Ausführungsbeispiele schematisch darstellen. Die verschiedenen Ansätze können sowohl miteinander als auch mit Vorrichtungen und Verfahren des Stands der Technik kombiniert werden.

**Patentansprüche**

1. Elektrooptischer Distanzmesser, insbesondere für einen Laserscanner (1'), Lasertracker, Profiler, Theodolit oder eine Totalstation (1), mit wenigstens

   • einer Lichtquelle (6) zum Aussenden wenigstens eines Lichtsignals als Sendelichtstrahl (13), insbesondere von Laserlicht, auf ein Zielobjekt (20),
- einer Empfangsschaltung mit einem Detektor mit einem photosensitiven Empfangsbauteil zum Empfangen des vom Zielobjekt zurückgestreuten Lichtsignals als Empfangslichtstrahl (12), und
- einer Steuer- und Auswertekomponente zum Ableiten einer Distanz zum Zielobjekt (20),

wobei

- der Detektor eine segmentierte Avalanche-Photodiode APD (8S) ist und das Empfangsbauteil mindestens zwei voneinander unabhängige APD-Segmente als Empfangssegmente (S1, S2, S3, S4, S5, S1i, S2a, S2al, S2ar, Sj) zum voneinander unabhängigen Erzeugen je eines resultierenden elektrischen Signals aufweist, wobei die Empfangssegmente (S1, S2, S3, S4, S5, S1i, S2a, S2al, S2ar, Sj) vordefinierten, unterschiedlichen, zu vermessenden Distanzbereichen zugeordnet sind,

**dadurch gekennzeichnet, dass**

- im Rahmen der Empfangsschaltung für die mindestens zwei Empfangssegmente (S1, S2, S3, S4, S5, S1i, S2a, S2al, S2ar, Sj) mindestens zwei unabhängige, unterschiedliche Verstärkungsfaktoren aufweisende Verstärker vorgesehen sind.

2. Distanzmesser nach Anspruch 1,
   **dadurch gekennzeichnet, dass**

   - der Sendelichtstrahl (13) im Wesentlichen kollimiert ist, also höchstens eine Divergenz von 0.5°, im Speziellen von 0.01°, aufweist, und
   - dem Detektor eine Bündelungsoptik mit Fixfokus vorgeordnet ist, insbesondere wobei der Detektor in der Brennebene der Bündelungsoptik positioniert ist.

3. Distanzmesser nach Anspruch 1 oder 2,
   **dadurch gekennzeichnet, dass**
   die Empfangssegmente so ausgebildet und angeordnet sind, dass aus den unterschiedlichen Distanzbereichen zurückgestreute Lichtsignale unterschiedliche definierte Empfangssegmentkombinationen beleuchten.

4. Distanzmesser nach einem der vorangehenden Ansprüche,
   **dadurch gekennzeichnet, dass**

   - für ein Empfangssegment der mindestens zwei Empfangssegmente, welches einem oberen Distanzbereich vergleichsweise ferner Distanzen zugeordnet ist, ein Verstärker mit vergleichsweise hohem Verstärkungsfaktor vorgesehen ist, und
   - für ein Empfangssegment der mindestens zwei Empfangssegmente, welches einem unteren Distanzbereich vergleichsweise naher Distanzen zugeordnet ist, ein Verstärker mit vergleichsweise geringem Verstärkungsfaktor vorgesehen ist.

5. Distanzmesser nach einem der vorangehenden Ansprüche,
   **dadurch gekennzeichnet, dass**
   die voneinander unabhängigen Empfangssegmente (S1, S2, S3, S4, S5, S1i, S2a, S2al, S2ar, Sj) nicht überlappen und jeweils zueinander beabstandet sind, insbesondere wobei die voneinander unabhängigen Empfangssegmente (S1, S2, S3, S4, S5, S1i, S2a, S2al, S2ar, Sj) radial verteilt, im Speziellen konzentrisch-kreisförmig, angeordnet sind.

6. Distanzmesser nach einem der vorangehenden Ansprüche,
   **dadurch gekennzeichnet, dass**
   im Rahmen der Empfangsschaltung jedem Empfangssegment (S1, S2, S3, S4, S5, S1i, S2a, S2al, S2ar, Sj) ein dezidierter, insbesondere für unterschiedliche Empfangssegmente jeweils separater, Signalverarbeitungspfad zugeordnet ist, insbesondere wobei die elektronischen Signale je einem eigenen Analog-Digital-Wandler zugeführt werden.

7. Distanzmesser nach einem der vorangehenden Ansprüche,
   **dadurch gekennzeichnet, dass**
   voneinander verschiedene Signalverarbeitungspfade separat elektronisch ansteuerbar und/oder auslesbar sind, insbesondere wobei Signale von unterschiedlichen Empfangssegmenten (S1, S2, S3, S4, S5, S1i, S2a, S2al, S2ar, Sj) aus zugeordneten unterschiedlichen Signalpfaden voneinander unterscheidbar auslesbar sind.

8. Distanzmesser nach einem der vorangehenden Ansprüche,
   **dadurch gekennzeichnet, dass**
   die Dimensionierung von Empfangssegmenten (S1, S2, S3, S4, S5, S1i, S2a, S2al, S2ar, Sj) und der Verstärkung in den zugehörigen Signalpfaden aufeinander sowie auch auf die jeweiligen aus unterschiedlichen Distanzbereichen zu erwartenden Return-Lichtsignale abgestimmt ist, insbesondere für eine Minimierung einer resultierenden Variation zwischen starken und schwachen Signalen als Signaldynamik (50i, 50a) und/oder Vergrösserung eines Signal-zu-Rauschen-Verhältnisses für die einzelnen Signalpfade.

9. Distanzmesser nach einem der vorangehenden Ansprüche,
   **dadurch gekennzeichnet, dass**
   wenigstens ein Empfangssegment so dimensioniert und angeordnet ist, dass ein von einem im Nahbereich, insbesondere < 5m, befindlichen Zielobjekt zurückgestreutes Lichtsignal mit - in einer Empfangsebene betrachtet - einem Strahlquerschnitt mit vglw. grossem Durchmesser und vglw. grosser zentraler Abschattung empfangbar ist, insbesondere wobei das Empfangssegment kreisringförmig oder kreisringsegmentförmig ausgebildet ist und einen Aussenkreisdurchmesser von mindestens 200 $\mu$m aufweist, im Speziellen von mindestens 500 $\mu$m.

10. Distanzmesser nach einem der vorangehenden Ansprüche, wobei der Distanzmesser für eine - was eine Bewegung von Sende- und/oder Empfangskomponenten des Distanzmesser betrifft - als statisch anzusehende Distanzmessung vorgesehen ist und der Sendelichtstrahl (13) und der Empfangslichtstrahl (12) koaxial zueinander verlaufen,
    **dadurch gekennzeichnet, dass**

    • die voneinander unabhängigen Empfangssegmente (S1, S2, S3, S4, S5, S1i, S2a, S2al, S2ar, Sj) radial verteilt, im Speziellen konzentrisch-kreisringförmig, angeordnet sind und/oder
    • dezidierte, insbesondere periphere, Empfangssegmente (S1, S2, S3, S4, S5, S1i, S2a, S2al, S2ar, Sj) in ihrer Dimensionierung angepasst sind für den Empfang grossflächiger Empfangslichtspots SP(12) für eine Bestimmung kurzer Distanzen zu einem Zielobjekt.

11. Distanzmesser nach einem der Ansprüche 1 bis 10, wobei der Distanzmesser für eine - was eine Bewegung von Sende- und/oder Empfangskomponenten des Distanzmesser betrifft - als dynamisch anzusehende Distanzmessung vorgesehen ist, insbesondere wobei der Sendelichtstrahl um mindestens eine Rotationsachse im Betrieb schell gedreht wird, und der Sendelichtstrahl (13) und der Empfangslichtstrahl (12) koaxial zueinander verlaufen,
    **dadurch gekennzeichnet, dass**
    die voneinander unabhängigen Empfangssegmente (S1, S2, S3, S4, S5, S1i, S2a, S2al, S2ar, Sj) achssymmetrisch radial verteilt, im Speziellen konzentrisch-kreisringförmig oder konzentrischkreisringsegmentförmig, angeordnet sind, wobei die Empfangssegmente - bezüglich ihres jeweiligen Ringradius und ihrer Dimensionierung - abhängig von einer vorgesehenen definierten Bewegung von Sende- und/oder Empfangskomponenten des Distanzmesser positioniert und ausgebildet sind.

12. Distanzmesser nach einem der Ansprüche 1 bis 10,
    **dadurch gekennzeichnet, dass**
    der Sendelichtstrahl (13) und der Empfangslichtstrahl (12) biaxial mit einem Versatz ($\Delta$B) zueinander verlaufen und zumindest eines der mindestens zwei Empfangssegmente (S1, S2, S3, S4, S5, S1i, S2a, S2al, S2ar, Sj) achs-asymmetrisch angeordnet ist.

13. Distanzmesser nach einem der vorangehenden Ansprüche,
    **dadurch gekennzeichnet, dass**
    die Steuer- und Auswertekomponente zum Ableiten einer Grobdistanzinformation ausgebildet ist anhand von einer Bestimmung, durch welche der vorhandenen Empfangssegmente jeweils ein elektrisches Signal erzeugt wird, und Auslesung des der bestimmten Kombination von beleuchteten Empfangssegmenten zugeordneten Distanzbereichs, im Speziellen wobei auch eine Signalstärkeverteilung unter den beleuchteten Empfangssegmenten bestimmt und für das Ableiten der Grobdistanzinformation herangezogen wird, insbesondere wobei die Steuer- und Auswertekomponente die jeweils abgeleitete Grobdistanzinformation im Rahmen einer Pulslaufzeit-Distanzmessung zur Auflösung einer sich in der Zuordnung von Sende- und Empfangspulsen ergebenden Mehrdeutigkeit, im Speziellen zur Lösung eines Mehrere-Pulse-in-der-Luft-Problems, herangezogen wird.

**14.** Elektrooptisches Distanzmessverfahren mit wenigstens einem

  • Aussenden eines Lichtsignals als Sendelichtstrahl (13), insbesondere von Laserlicht, auf ein Zielobjekt (20),
  • Empfangen und Detektieren eines vom Zielobjekt (20) zurückkommenden Anteils (42) des ausgesandten Lichtsignals als Empfangslichtstrahl (12), und
  • Bestimmen einer Distanz zum Zielobjekt (20), insbesondere im Millimeter- oder Submillimeterbereich,

  wobei

  • das Empfangen und Detektieren innerhalb mindestens zweier voneinander unabhängiger Empfangssegmente (S1, S2, S3, S4, S5, S1i, S2a, S2al, S2ar, Sj) zum voneinander unabhängigen Erzeugen je eines resultierenden elektrischen Signals erfolgt, wobei die Empfangssegmente (S1, S2, S3, S4, S5, S1i, S2a, S2al, S2ar, Sj) vordefinierten, unterschiedlichen, zu vermessenden Distanzbereichen zugeordnet sind,

  **dadurch gekennzeichnet, dass**

  • die voneinander unabhängig erzeugten elektrischen Signale unabhängig voneinander, mit unterschiedlichen Verstärkungsfaktoren verstärkt werden, und
  • das Empfangen und Detektieren mit einer Empfangsschaltung mit einem Detektor mit einem photosensitiven Empfangsbauteil erfolgt, wobei der Detektor eine segmentierte Avalanche-Photodiode APD (8S) ist und das Empfangsbauteil die mindestens zwei voneinander unabhängigen Empfangssegmente (S1, S2, S3, S4, S5, S1i, S2a, S2al, S2ar, Sj), welche APD-Segmente sind, aufweist, und wobei im Rahmen der Empfangsschaltung für die mindestens zwei Empfangssegmente (S1, S2, S3, S4, S5, S1i, S2a, S2al, S2ar, Sj) mindestens zwei unabhängige, die unterschiedlichen Verstärkungsfaktoren aufweisende Verstärker vorgesehen sind.

**15.** Elektrooptisches Distanzmessverfahren nach Anspruch 14,
  **dadurch gekennzeichnet, dass**

  die von den unterschiedlichen Empfangssegmenten (S1, S2, S3, S4, S5, S1i, S2a, S2al, S2ar, Sj) voneinander unabhängig erzeugten elektrischen Signale aus jeweils zugeordneten unterschiedlichen Signalpfaden voneinander unterscheidbar ausgelesen werden, insbesondere wobei aus dem Vergleich von den erzeugten Signalen eine Grobdistanzinformation bestimmt wird, insbesondere unter Berücksichtigung einer ermittelten Grösse eines Empfangslichtspots SP(12),
  im Speziellen wobei - insbesondere bei Verwendung eines LIDAR-Systems - die bestimmte Grobdistanzinformation dazu verwendet wird, eine Distanzbestimmung zu Fehlzielen, insbesondere durch Lichtstreuung an Luftpartikeln, durch Ausschluss vordefinierter oder vordefinierbarer Minimaldistanzen zu unterbinden und/oder wobei - bei Verwendung eines Pulslaufzeitmessprinzips - die bestimmte Grobdistanzinformation dazu verwendet wird, eine sich allfällig in der Zuordnung von Sende- und Empfangspulsen ergebende Mehrdeutigkeit aufzulösen.

## Claims

**1.** Electrooptical distance measuring device, in particular for a laser scanner (1'), laser tracker, profiler, theodolite or a total station (1), comprising at least

  • a light source (6) for emitting at least one light signal as transmission light beam (13), in particular laser light, onto a target object (20),
  • a reception circuit comprising a detector comprising a photosensitive reception component for receiving the light signal backscattered from the target object as reception light beam (12), and
  • a control and evaluation component for deriving a distance to the target object (20),

  wherein

  • the detector is a segmented avalanche photodiode APD (8S) and the reception component has at least two mutually independent APD-segments as reception segments (S1, S2, S3, S4, S5, S1i, S2a, S2al, S2ar, Sj) for mutually independently generating a respective resultant electrical signal, wherein the reception segments (S1, S2, S3, S4, S5, S1i, S2a, S2al, S2ar, Sj) are assigned to predefined, different distance ranges to be measured,

**characterized in that**

> • at least two independent amplifiers having different gain factors are provided in the context of the reception circuit for the at least two reception segments (S1, S2, S3, S4, S5, S1i, S2a, S2al, S2ar, Sj).

2. Distance measuring device according to Claim 1,
   **characterized in that**

> • the transmission light beam (13) is substantially collimated, that is to say has at most a divergence of 0.5°, specifically of 0.01°, and
> • a focusing optical unit having a fixed focus is disposed upstream of the detector, in particular wherein the detector is positioned in the focal plane of the focusing optical unit.

3. Distance measuring device according to Claim 1 or 2,
   **characterized in that**
   the reception segments are embodied and arranged such that light signals backscattered from the different distance ranges illuminate different defined reception segment combinations.

4. Distance measuring device according to any one of the preceding claims,
   **characterized in that**

> • an amplifier having a comparatively high gain factor is provided for a reception segment of the at least two reception segments which is assigned to an upper distance range of comparatively far distances, and
> • an amplifier having a comparatively low gain factor is provided for a reception segment of the at least two reception segments which is assigned to a lower distance range of comparatively near distances.

5. Distance measuring device according to any one of the preceding claims,
   **characterized in that**
   the mutually independent reception segments (S1, S2, S3, S4, S5, S1i, S2a, S2al, S2ar, Sj) do not overlap and are in each case spaced apart from one another, in particular wherein the mutually independent reception segments (S1, S2, S3, S4, S5, S1i, S2a, S2al, S2ar, Sj) are arranged in a radially distributed fashion, especially in a concentric-circular fashion.

6. Distance measuring device according to any one of the preceding claims,
   **characterized in that**
   a dedicated signal processing path, in particular separate in each case for different reception segments, is assigned to each reception segment (S1, S2, S3, S4, S5, S1i, S2a, S2al, S2ar, Sj) in the context of the reception circuit, in particular wherein the electronic signals are fed in each case to a dedicated analog-to-digital converter.

7. Distance measuring device according to any one of the preceding claims,
   **characterized in that**
   mutually different signal processing paths are separately electronically drivable and/or readable, in particular wherein signals from different reception segments (S1, S2, S3, S4, S5, S1i, S2a, S2al, S2ar, Sj) are readable from assigned different signal paths in a manner distinguishable from one another.

8. Distance measuring device according to any one of the preceding claims,
   **characterized in that**
   the dimensioning of reception segments (S1, S2, S3, S4, S5, S1i, S2a, S2al, S2ar, Sj) and of the gain in the associated signal paths is coordinated with one another and also with the respective return light signals to be expected from different distance ranges, in particular for a minimization of a resultant variation between strong and weak signals as signal dynamic range (50i, 50a) and/or magnification of a signal-to-noise ratio for the individual signal paths.

9. Distance measuring device according to any one of the preceding claims,
   **characterized in that**
   at least one reception segment is dimensioned and arranged such that a light signal backscattered from a target object situated in the near range, in particular < 5 m, and having - as viewed in a reception plane - a beam cross section having a comparatively large diameter and comparatively large central shading is receivable, in particular wherein the reception segment is embodied in an annular fashion or in an annulus-segment-shaped fashion and has an outer circle diameter of at least 200 $\mu$m, specifically of at least 500 $\mu$m.

10. Distance measuring device according to any one of the preceding claims, wherein the distance measuring device is provided for a distance measurement to be regarded as static - as far as a movement of transmission and/or reception components of the distance measuring device is concerned - and the transmission light beam (13) and the reception light beam (12) run coaxially with respect to one another,
**characterized in that**

   • the mutually independent reception segments (S1, S2, S3, S4, S5, S1i, S2a, S2al, S2ar, Sj) are arranged in a radially distributed fashion, specifically in a concentric-annular fashion, and/or
   • dedicated, in particular peripheral, reception segments (S1, S2, S3, S4, S5, S1i, S2a, S2al, S2ar, Sj) are adapted in terms of their dimensioning for the reception of large-area reception light spots SP(12) for a determination of short distances to a target object.

11. Distance measuring device according to any one of Claims 1 to 10, wherein the distance measuring device is provided for a distance measurement to be regarded as dynamic - as far as a movement of transmission and/or reception components of the distance measuring device is concerned - , in particular wherein the transmission light beam is rapidly rotated about at least one rotation axis during operation, and the transmission light beam (13) and the reception light beam (12) run coaxially with respect to one another,
**characterized in that**
the mutually independent reception segments (S1, S2, S3, S4, S5, S1i, S2a, S2al, S2ar, Sj) are arranged in an axially symmetrically radially distributed fashion, specifically in a concentric-annular fashion or in a concentric-annulus-segment-shaped fashion, wherein the reception segments - with regard to their respective ring radius and their dimensioning - are positioned and embodied depending on a provided defined movement of transmission and/or reception components of the distance measuring device.

12. Distance measuring device according to any one of Claims 1 to 10,
**characterized in that**
the transmission light beam (13) and the reception light beam (12) run biaxially with an offset ($\Delta$B) with respect to one another and at least one of the at least two reception segments (S1, S2, S3, S4, S5, S1i, S2a, S2al, S2ar, Sj) is arranged axially asymmetrically.

13. Distance measuring device according to any one of the preceding claims,
**characterized in that**
the control and evaluation component is designed for the derivation of coarse distance information on the basis of a determination of which of the reception segments present generates a respective electrical signal, and read-out of the distance range assigned to the determined combination of illuminated reception segments, specifically wherein a signal strength distribution among the illuminated reception segments is also determined and used for the derivation of the coarse distance information, in particular wherein the control and evaluation component uses the respectively derived coarse distance information in the context of a pulse time-of-flight distance measurement for resolving an ambiguity that arises in the assignment of transmission and reception pulses, specifically for solving a multiple-pulses-in-the-air problem.

14. Electrooptical distance measuring method comprising at least

   • emitting a light signal as transmission light beam (13), in particular laser light, onto a target object (20), and
   • receiving and detecting a portion (42) of the emitted light signal that returns from the target object (20) as reception light beam (12), and
   • determining a distance to the target object (20), in particular in the millimeter or submillimeter range,

wherein

   • receiving and detecting are carried out within at least two mutually independent reception segments (S1, S2, S3, S4, S5, S1i, S2a, S2al, S2ar, Sj) for mutually independently generating a respective resultant electrical signal, wherein the reception segments (S1, S2, S3, S4, S5, S1i, S2a, S2al, S2ar, Sj) are assigned to predefined, different distance ranges to be measured,

**characterized in that**

• the mutually independently generated electrical signals are amplified independently of one another with different gain factors, and
• the receiving and detecting are carried out with a reception circuit comprising a detector comprising a photosensitive reception component, wherein the detector is a segmented avalanche photodiode APD (8S) and the reception component has the at least two mutually independent reception segments (S1, S2, S3, S4, S5, S1i, S2a, S2al, S2ar, Sj), which are APD segments, and wherein the at least two independent amplifiers having different gain factors are provided in the context of the reception circuit for the at least two reception segments (S1, S2, S3, S4, S5, S1i, S2a, S2al, S2ar, Sj).

**15.** Electrooptical distance measuring method according to Claim 14,
**characterized in that**

the electrical signals generated by the different reception segments (S1, S2, S3, S4, S5, S1i, S2a, S2al, S2ar, Sj) independently of one another are read from respectively assigned different signal paths in a manner distinguishable from one another, in particular wherein coarse distance information is determined from the comparison of the generated signals, in particular taking account of an ascertained size of a reception light spot SP(12), specifically wherein - in particular when a LIDAR system is used - the determined coarse distance information is used to prevent a distance determination with respect to incorrect targets, in particular as a result of light scattering at air particles, by predefined or predefinable minimal distances being excluded, and/or wherein - when a pulse time-of-flight measurement principle is used - the determined coarse distance information is used to resolve an ambiguity that possibly arises in the assignment of transmission and reception pulses.

**Revendications**

**1.** Dispositif de mesure de distance électro-optique, notamment destiné à un dispositif de balayage à laser (1'), à un dispositif de poursuite à laser, à un profileur, à un théodolite, ou à une station totale (1), comportant au moins

- une source lumineuse (6) destinée à émettre au moins un signal lumineux en tant que faisceau lumineux d'émission (13), notamment de lumière laser, vers un objet cible (20),
- un circuit de réception comportant un détecteur ayant un composant de réception photosensible destiné à recevoir le signal lumineux rétrodiffusé par l'objet cible en tant que faisceau lumineux de réception (12), et
- un composant de commande et d'analyse destiné à déduire une distance par rapport à l'objet cible (20), dans lequel
- le détecteur est une photodiode à avalanche APD segmentée (8S) et le composant de réception comporte au moins deux segments d' APD en tant que segments de réception (S1, S2, S3, S4, S5, S1i, S2a, S2al, S2ar, Sj) indépendants l'un de l'autre, pour générer indépendamment l'un de l'autre un signal électrique résultant respectif, dans lequel les segments de réception (S1, S2, S3, S4, S5, S1i, S2a, S2al, S2ar, Sj) sont associés à des plages de distances à mesurer prédéfinies, différentes, **caractérisé en ce que**
- il est prévu au moins deux amplificateurs indépendants, présentant des facteurs d'amplification différents, au sein du circuit de réception destiné aux au moins deux segments de réception (S1, S2, S3, S4, S5, S1i, S2a, S2al, S2ar, Sj).

**2.** Dispositif de mesure de distance selon la revendication 1,
**caractérisé en ce que**

- le faisceau lumineux d'émission (13) est sensiblement collimaté, et présente par conséquent une divergence maximale de 0.5° et plus particulièrement, de 0.01°, et
- une optique de collimation à foyer fixe est disposée en amont du détecteur, le détecteur étant notamment positionné dans le plan focal de l'optique de collimation.

**3.** Dispositif de mesure de distance selon la revendication 1 ou 2,
**caractérisé en ce que** les segments de réception sont conçus et agencés de manière à ce que des signaux lumineux rétrodiffusés depuis des plages de distances différentes éclairent des combinaisons définies différentes de segments de réception.

**4.** Dispositif de mesure de distance selon l'une quelconque des revendications précédentes,
**caractérisé en ce que**

- il est prévu un amplificateur ayant un facteur d'amplification relativement élevé pour un segment de réception des au moins deux segments de réception qui est associé à une plage de distances supérieure de distances relativement supérieure, et
- il est prévu un amplificateur ayant un facteur d'amplification relativement faible pour un segment de réception des au moins deux segments de réception, qui est associé à une plage de distances inférieure de distances relativement proches.

5. Dispositif de mesure de distance selon l'une quelconque des revendications précédentes,
   **caractérisé en ce que** les segments de réception (S1, S2, S3, S4, S5, S1i, S2a, S2al, S2ar, Sj) indépendants les uns des autres ne se chevauchent pas et sont respectivement espacés les uns des autres, et plus particulièrement, dans lequel les segments de réception (S1, S2, S3, S4, S5, S1i, S2a, S2al, S2ar, Sj) indépendants les uns des autres sont disposés de manière répartie radialement, notamment sous la forme de cercles concentriques.

6. Dispositif de mesure de distance selon l'une quelconque des revendications précédentes,
   **caractérisé en ce qu'**à chaque segment de réception (S1, S2, S3, S4, S5, S1i, S2a, S2al, S2ar, Sj) est associé, au sein du circuit de réception, un trajet de traitement du signal respectif séparé souhaité, notamment pour des segments de réception différents, et plus particulièrement, dans lequel les signaux électroniques sont respectivement délivrés à un convertisseur analogique-numérique propre.

7. Dispositif de mesure de distance selon l'une quelconque des revendications précédentes,
   **caractérisé en ce que** des trajets de traitement de signal différents les uns des autres peuvent être attaqués et/ou lus électroniquement de manière séparée, et plus particulièrement, dans lequel des signaux de segments de réception (S1, S2, S3, S4, S5, S1i, S2a, S2al, S2ar, Sj) différents peuvent être lus de manière différentielle les uns des autres à partir de trajets de signaux associés différents.

8. Dispositif de mesure de distance selon l'une quelconque des revendications précédentes,
   **caractérisé en ce que** le dimensionnement des segments de réception (S1, S2, S3, S4, S5, S1i, S2a, S2al, S2ar, Sj) sont accordés les uns aux autres sur les trajets de signaux associés et sur les signaux lumineux de retour respectifs attendus en provenance de plages de distances différentes, et plus particulièrement, pour une minimisation d'une variation produite entre des signaux forts et faibles en tant que dynamique du signal (50i, 50a) et/ou pour une augmentation d'un rapport signal à bruit pour les trajets de signaux individuels.

9. Dispositif de mesure de distance selon l'une quelconque des revendications précédentes,
   **caractérisé en ce qu'**au moins un segment de réception est dimensionné et agencé de manière à ce qu'un signal lumineux rétrodiffusé par un objet cible se trouvant dans un domaine proche, notamment < 5 m, puisse être reçu avec une section transversale de faisceau - observée dans un plan de réception - ayant un diamètre relativement élevé et un obscurcissement central relativement élevé, et plus particulièrement, dans lequel le segment de réception est réalisé sous forme circulaire ou sous forme d'arc de cercle et présente un diamètre de cercle extérieur d'au moins 200 $\mu$m, et plus particulièrement, d'au moins 500 $\mu$m.

10. Dispositif de mesure de distance selon l'une quelconque des revendications précédentes, dans lequel le dispositif de mesure de distance est prévu pour une mesure de distance devant être considérée comme statique - cela concernant un déplacement de composants d'émission et/ou de réception du dispositif de mesure de distance - et le faisceau lumineux d'émission (13) et le faisceau lumineux de réception (12) s'étendent coaxialement l'un par rapport à l'autre,
    **caractérisé en ce que**

    - les segments de réception (S1, S2, S3, S4, S5, S1i, S2a, S2al, S2ar, Sj) indépendants les uns des autres sont disposés de manière répartie radialement, et plus particulièrement sous la forme de cercles concentriques, et/ou
    - des segments de réception (S1, S2, S3, S4, S5, S1i, S2a, S2al, S2ar, Sj) souhaités, notamment périphériques, sont adaptés du point de vue de leur dimensionnement pour la réception de points lumineux de réception de superficie élevée SP(12) afin de déterminer de faibles distances par rapport à un objet cible.

11. Dispositif de mesure de distance selon l'une quelconque des revendications 1 à 10, dans lequel le dispositif de mesure de distance est prévu pour une mesure de distance devant être considérée comme étant dynamique - cela concernant un déplacement de composants d'émission et/ou de réception du dispositif de mesure de distance - et plus particulièrement, dans lequel le faisceau lumineux d'émission est soumis, lors du fonctionnement, à une rotation rapide autour d'un axe de rotation, et le faisceau lumineux d'émission (13) et le faisceau lumineux de réception (12) s'étendent coaxialement l'un par rapport à l'autre,
**caractérisé en ce que** les segments de réception (S1, S2, S3, S4, S5, S1i, S2a, S2al, S2ar, Sj) indépendants les uns des autres sont disposés de manière répartie axisymétriquement radialement, et plus particulièrement sous la forme de cercles concentriques ou d'arcs de cercle concentriques, dans lequel les segments de réception - en ce qui concerne leur rayon annulaire respectif et à leurs dimensions - sont positionnés et réalisés dépendamment d'un déplacement prévu défini de composants d'émission et/ou de réception du dispositif de mesure de distance.

**12.** Dispositif de mesure de distance selon l'une quelconque des revendications 1 à 10,
**caractérisé en ce que** le faisceau lumineux d'émission (13) et le faisceau lumineux de réception (12) s'étendent de manière biaxiale l'un par rapport à l'autre avec un décalage (∆B) et au moins l'un des au moins deux segments de réception (S1, S2, S3, S4, S5, S1i, S2a, S2al, S2ar, Sj) est disposé de manière axialement asymétrique.

**13.** Dispositif de mesure de distance selon l'une quelconque des revendications précédentes,
**caractérisé en ce que** le composant de commande et d'analyse est conçu pour déduire une information de distance grossière sur la base d'une détermination au moyen de laquelle un signal électrique respectif est généré par les segments de réception présents, et d'une lecture de la plage de distances associée à la combinaison déterminée de segments de réception éclairés, et plus particulièrement, dans lequel une distribution d'intensité des signaux est également déterminée pour les segments de réception éclairés et est prise en compte pour la déduction de l'information de distance grossière, et plus particulièrement, dans lequel le composant de commande et d'analyse utilise l'information de distance grossière respective déduite dans le cadre d'une mesure de distance utilisant le temps de propagation des impulsions pour lever une ambiguïté apparaissant lors de l'association d'impulsions d'émission et de réception, et plus particulièrement pour résoudre un problème d'impulsions multiples se propageant.

**14.** Procédé de mesure de distance électro-optique consistant au moins à :

- émettre un signal lumineux sous la forme d'un faisceau lumineux d'émission (13), notamment de lumière laser, vers un objet cible (20),
- recevoir et détecter une partie (42) du signal lumineux émis renvoyée par l'objet cible (20) en tant que faisceau lumineux de réception (12), et
- déterminer une distance par rapport à l'objet cible (20), notamment dans le domaine millimétrique ou submillimétrique,

dans lequel

- la réception et la détection s'effectuent à l'intérieur d'au moins deux segments de réception (S1, S2, S3, S4, S5, S1i, S2a, S2al, S2ar, Sj) indépendants l'un de l'autre, pour générer indépendamment l'un de l'autre un signal électrique résultant respectif, dans lequel les segments de réception (S1, S2, S3, S4, S5, S1i, S2a, S2al, S2ar, Sj) sont associés à des plages de distances à mesurer prédéfinies, différentes, **caractérisé en ce que**
- les signaux électriques générés indépendamment les uns des autres sont amplifiés indépendamment les uns des autres avec des facteurs d'amplification différents, et
- la réception et la détection s'effectuent au moyen d'un circuit de réception comportant un détecteur ayant un composant de réception photosensible, dans lequel le détecteur est une photodiode à avalanche APD segmentée (8S) et ledit composant de réception comporte au moins les deux segments de réception (S1, S2, S3, S4, S5, S1i, S2a, S2al, S2ar, Sj) indépendants, ledit segments de réception sont segments d' APD, et dans lequel, il est prévu au moins deux amplificateurs indépendants, présentant les facteurs d'amplification différents, au sein du circuit de réception destiné aux au moins deux segments de réception (S1, S2, S3, S4, S5, S1i, S2a, S2al, S2ar, Sj).

**15.** Procédé de mesure de distance électro-optique selon la revendication 14,

**caractérisé en ce que** les signaux électrique générés indépendamment les uns des autres par les différents segments de réception (S1, S2, S3, S4, S5, S1i, S2a, S2al, S2ar, Sj) sont également lus de manière différentiable les uns par rapport aux autres à partir de trajets de signaux différents associés respectifs, et plus particulièrement, dans lequel une information de distance grossière est déterminée à partir de la comparaison des signaux générés, notamment en tenant compte d'une taille déterminée d'un point lumineux de réception SP(12), et plus particulièrement, dans lequel - notamment lors de l'utilisation d'un système LIDAR - l'information de distance grossière déterminée est utilisée pour empêcher une détermination de distance par rapport à des cibles erronées, notamment du fait de la diffusion lumineuse sur des particules d'air, en excluant des distances minimales prédéfinies ou pouvant être prédéfinies et/ou - lors de l'utilisation d'un principe de mesure de temps de propagation d'impulsions - l'information de distance grossière déterminée est utilisée pour lever une ambiguïté pouvant se produire dans l'association d'impulsions d'émission et de réception.

Fig. 1

Fig. 2

Fig. 3a

Fig. 3b

S

31′  31    30    30′

40

40′

31′  31

32

32′

d1m                    d1                    d

*Fig. 4a*

S

40

30

50i

51a        52a

50i    50a

51i

SP(12)

52i

S1i

SP(12)

8S

S2a

50a   ΔSj

S2a

d2a              d1i

*Fig. 4b*

$\Phi$ [W]

$\Phi e_{APDi}(D_j)$

$\Phi e_{APDa}(D_j)$

$\Phi_{sum}(D_j)$

$D_j$ [m]

Fig. 5

Fig. 6a

**20**

0 m  10 m  100 m  500 m  d

ΔB

SP(12)

S1

S2

S3

a1

a2

8S

*Fig. 6b*

d = 150 m   Δy = 63 µm   SP(12) = 33 µm  ⟹

d = 300 m   Δy = 120 µm  SP(12) = 17 µm  ⟹

d = 450 m   Δy = 183 µm  SP(12) = 11 µm ⟹

s(SP)

Δy

Δy

*Fig. 7a*

20

12

s(22)

OA

13

12

α

Δy

s(SP)

SP(12)

22

*Fig. 7b*

d = 20 m   Δb = 150 µm   Δy = ca. 0 µm
SP(12) = 250 µm

SP(12)
s(SP)
Δb
OA

d = 150 m   Δb = 20 µm   Δy = 63 µm
d(s) = 33 µm

SP(12)
s(SP)
Δb
OA
Δy

d = 300 m   Δb = 10 µm   Δy = ca. 126 µm
SP(12) = 17 µm

SP(12)
s(SP)
Δb
OA
Δy

d = 450 m   Δb = 7 µm   Δy = ca. 189 µm
SP(12) = 11 µm

SP(12)
s(SP)
Δb
OA
Δy

*Fig. 7c*

*Fig. 8*

Fig. 9

Fig. 10

*Fig. 11a*

**Fig. 11b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1686350 A
- DE 102006013290